(19) **Europäisches Patentamt / European Patent Office / Office européen des brevets**

(11) **EP 3 695 505 B1**

(12) **FASCICULE DE BREVET EUROPEEN**

(45) Date de publication et mention de la délivrance du brevet:
**02.07.2025 Bulletin 2025/27**

(21) Numéro de dépôt: **18795311.2**

(22) Date de dépôt: **12.10.2018**

(51) Classification Internationale des Brevets (IPC):
**H02N 2/18** *(2006.01)*

(52) Classification Coopérative des Brevets (CPC):
**H02N 2/181; H02N 2/18**

(86) Numéro de dépôt international:
**PCT/EP2018/077959**

(87) Numéro de publication internationale:
**WO 2019/073066 (18.04.2019 Gazette 2019/16)**

(54) **PROCEDE DE PILOTAGE D'UNE ALIMENTATION ELECTRIQUE AUTONOME PAR TRANSDUCTEUR PIEZOELECTRIQUE, CIRCUIT D'ALIMENTATION ET DISPOSITIF AINSI ALIMENTE**

**STEUERUNGSVERFAHREN EINER AUTONOMEN ELEKTRISCHEN VERSORGUNG DURCH PIEZOELEKTRISCHEN WANDLER, VERSORGUNGSSCHALTKREIS UND HIERDURCH VERSORGTES GERÄT**

**CONTROL METHOD OF AN AUTONOMOUS ELECTRIC SUPPLY BY PIEZOELECTRIC TRANSDUCER, SUPPLY CIRCUIT AND DEVICE SUPPLIED THEREBY**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **13.10.2017 FR 1759642**
**19.10.2017 FR 1759869**

(43) Date de publication de la demande:
**19.08.2020 Bulletin 2020/34**

(73) Titulaire: **Korea Electronics Technology Institute Bundang-gu, Seongnam-si Gyeonggi-do 463-816 (KR)**

(72) Inventeurs:
• **BRENES, Alexis**
**92340 Bourg-La-Reine (FR)**
• **LEFEUVRE, Elie**
**93100 Montreuil (FR)**
• **YOO, Chan Sei**
**Ayang-Si**
**Gyeonggi-do 14063 (KR)**

(74) Mandataire: **Isarpatent**
**Patent- und Rechtsanwälte Barth**
**Charles Hassa Peckmann & Partner mbB**
**Postfach 44 01 51**
**80750 München (DE)**

(56) Documents cités:
WO-A1-2017/191436    KR-A- 20140 131 005
US-A1- 2003 034 715    US-A1- 2014 062 256
US-A1- 2015 263 643

• DETERRE M ET AL: "Paper;An active piezoelectric energy extraction method for pressure energy harvesting;An active piezoelectric energy extraction method for pressure energy harvesting", SMART MATERIALS AND STRUCTURES, IOP PUBLISHING LTD., BRISTOL, GB, vol. 21, no. 8, 13 July 2012 (2012-07-13), pages 85004, XP020227450, ISSN: 0964-1726, DOI: 10.1088/0964-1726/21/8/085004
• ZAWAWI A EL ET AL: "Recursive least squares Harmonic identification in active power filters", 2007 EUROPEAN CONTROL CONFERENCE (ECC), IEEE, 2 July 2007 (2007-07-02), pages 4645 - 4650, XP032751958, ISBN: 978-3-9524173-8-6, [retrieved on 20150325]

**Description**

La présente invention telle que définie par les revendications propose un procédé de pilotage d'un circuit de récolte d'énergie électrique produite par un transducteur piézoélectrique, formant un résonateur piézoélectrique sous l'effet de vibrations issues d'une source d'excitation mécanique. Ce circuit produit une tension de sortie continue par l'intermédiaire d'un convertisseur DC-DC fonctionnant par PWM, qui est piloté par un signal commandant son rapport de cycle avec une valeur actuelle. Ce procédé comprend typiquement :

un processus d'estimation incluant les opérations suivantes, pendant le fonctionnement du circuit de récolte :

- détection du signal de tension piézo,
- évaluation de l'amplitude d'une harmonique individuelle dudit signal piézo, d'un rang supérieur à un, et par exemple de rang trois,
- estimation d'une nouvelle résistance équivalente à produire par le convertisseur, et d'un nouveau rapport de cycle à commander pour le convertisseur ;

un processus d'adaptation d'impédance par application au convertisseur d'un nouveau signal de consigne pour commander le nouveau rapport de cycle et produire la nouvelle résistance ;
un processus de fonctionnement nominal, avec une valeur constante du signal de pilotage du convertisseur.

<u>Etat de la technique</u>

Il existe de nombreux appareils qui comprennent une partie électrique ou électronique et doivent fonctionner de manière autonome pendant une longue durée sans être connectés à une source électrique extérieure, ou au moins pendant une durée plus longue que ce que permettrait l'énergie initialement stockés à l'intérieur.

De tels appareils peuvent être par exemple différentes sortes de capteurs de mesure ou de détection, avec des fonctionnalités d'enregistrement voire de communication sans fil. Il peut s'agir d'appareil mobiles ou embarqués, ou devant être répartis dans des zones étendues, tels que des récepteurs radio ou des capteurs environnementaux. Il peut aussi s'agir de différentes sortes d'appareils à faible consommation qui sont implantés dans le corps humain ou animal in vivo, où il est difficile de leur fournir une connexion électrique de recharge, comme un pacemaker. D'autres appareils sont aussi concernés, comme par exemple des appareils portables ou des vêtements intelligents, ou des appareils de surveillance, ou des balises de positionnement

Pour l'alimentation électrique de tels appareil, il est connu d'y intégrer du dispositif de récolte d'énergie afin d'extraire de l'énergie électrique à partir d'une source locale d'énergie mécanique disponible sous une forme alternative, par exemple des vibrations ou des variations de pression dans un fluide ou des déformations mécaniques répétitives.

Une telle énergie mécanique peut être récoltée par différents types de convertisseurs, aussi appelés transducteurs. Les transducteurs de type piézoélectrique utilisent les efforts ou les déformations appliqués à un matériau qui présente des propriétés piézoélectriques. Ce matériau piézoélectrique est intégré dans un résonateur mécanique qui est excité par les forces mécaniques de l'environnement, et il convertit ainsi cette énergie mécanique en énergie électrique. Ce type de transduction est bien adapté à la miniaturisation.

Typiquement, l'énergie électrique est produite sous la forme d'une tension alternative qui est alors redressée, puis ajustée ou régulée par un convertisseur pour alimenter le consommateur et/ou pour recharger une batterie.

Le document EP1612059 divulgue un appareil embarqué dans un pneumatique de véhicule, dans la partie intérieure de la couronne du pneu. Lorsque le véhicule roule, les contraintes mécaniques associées à la flexion du pneu sont transformées en énergie électrique par un transducteur piézoélectrique, sous la forme d'une tension alternative. Cette énergie est récoltée par un circuit de récolte incluant un convertisseur par hachage, et stockée dans un dispositif de stockage. Cette énergie stockée peut alors alimenter un système électronique qui inclut des composant de mesure de différents paramètres du pneumatique comme la température et la pression interne, ainsi qu'un dispositif de transmission radio qui transmet ces mesures et d'autres données à un récepteur fixé dans le véhicule.

Le document US2015263643 divulgue un circuit de récolte, dans lequel le signal alternatif de sortie du transducteur est converti en courant continu par un convertisseur AC-DC formant un étage de type SSHI, pour "Synchronized Switch Harvesting on an Inductor". Ce dernier produit simultanément un redressement du signal et aussi une rectification de la forme du signal en vue d'en optimiser la récupération d'énergie dans les configurations à faible couplage. Il réalise ces fonctions par un même procédé synchrone, en actionnant plusieurs interrupteurs à différents instants du cycle de façon commandée par un module de contrôle, en fonction de la tension continue obtenue en sortie de ce convertisseur. Dans ce document, la tension ainsi redressée et corrigée sert de base pour ajuster en aval l'impédance d'un convertisseur DC-DC.

Dans de nombreux contextes applicatifs, l'accélération reçue par le résonateur de la part de l'environnement peut varier avec le temps, à la fois en amplitude et en fréquence. Ces variations de fréquence et d'amplitude sont en général lentes par rapport à la période de cette excitation mécanique. D'autres paramètres peuvent varier aussi, en particulier des paramètres qui sont inhérents au résonateur lui-même. Ces autres paramètres pouvant varier peuvent comprendre :

- le facteur de qualité mécanique du transducteur, car l'amortissement dépend de l'usure de la fixation du résonateur et de la fixation du transducteur dans le résonateur ; et
- la capacité, en raison de l'usure du matériau piézoélectrique lui-même.

Dans ce cadre, il a été proposé de réaliser des dispositifs adaptatifs, muni d'une capacité de Maximum Power Point Tracking, qui permet d'adapter le système de récupération d'énergie à un point de fonctionnement qui correspond au maximum de récupération de puissance.

Parmi ces solutions adaptatives, une méthode est basée sur l'utilisation en continu d'un circuit de contrôle qui estime la puissance récupérée, en mesurant le courant transféré à la batterie. Par exemple la publication Ottman et al., "Adaptive piezoelectric energy harvesting circuit for wireless remote power supply," IEEE Transactions on Power Electronics, vol. 17, no. 5, pp. 669-676, September 2002. Cette méthode est simple à mettre en place et indépendante des caractéristiques du résonateur, mais elle nécessite l'utilisation d'un système spécifique de mesure du courant, et un post-traitement par un circuit spécialisé de type Digital Signal Processor (DSP). Les DSP sont des systèmes de traitement avancé de signal, très puissants mais qui consomment une puissance importante, par exemple par rapport aux microcontrôleurs.

Une autre méthode d'adaptation présente une succession d'itérations d'une phase courte de test, de l'ordre de quelques périodes d'oscillation, et d'une phase longue de fonctionnement normal de production d'énergie. Lors de la phase de mesure, le circuit électrique du transducteur piézoélectrique est interrompu ou perturbé, de façon à détecter les conditions de fonctionnement actuelles. Cette mesure est utilisée pour recalculer des paramètres de pilotage du circuit de récolte, et ainsi ajuster son point de fonctionnement pour la suite, afin de maximiser la puissance récoltée. Les vibrations de l'environnement et les paramètres sont ensuite supposés invariants pendant la phase de fonctionnement normal qui s'ensuivra. Une telle méthode d'ajustement est divulguée par la publication Xia et al., "Direct calculation of source impedance to adaptive maximum power point tracking for broadband vibration," Journal of Intelligent Material Systems and Structures, September 2016.

Or la méthode d'ajustement utilisée dans cette publication suppose que les perturbations électriques ne modifient pas ou peu le comportement mécanique, ce qui n'est valable que pour un système très faiblement couplé. De plus, cette méthode suppose aussi que le transducteur est une source idéale, ce qui n'est valable aussi que pour un résonateur très faiblement couplé.

Cette méthode utilise un calcul d'adaptation d'impédance du circuit de récolte pour maximiser la puissance produite, pour un résonateur piézoélectrique branché sur un redresseur et un convertisseur buck-boost.

Ce calcul d'adaptation d'impédance consiste à évaluer la résistance électrique équivalente du circuit formé par le convertisseur et la batterie si elle existe, pour choisir le réglage qui sera imposé au convertisseur-régulateur. Ce calcul d'adaptation est basé sur une théorie générale, formant une modélisation mathématique du comportement du circuit de collecte. Il est réalisé à partir des caractéristiques théoriques du circuit, en particulier la capacité maximale $C_p$ du transducteur piézoélectrique, tels qu'il est initialement conçu et/ou fabriqué.

Cette théorie générale est présentée par exemple dans la publication Shu and Lien, "Analysis of power output for piezoelectric energy harvesting systems," Smart Materials and Structures, vol. 15, pp. 1499-1512, 2006.

Ce type de méthode présente toutefois des inconvénients, et n'est pas facilement adaptable à toutes les configurations. Par exemple, une telle méthode nécessite de modifier ou perturber le régime de fonctionnement du système pendant la phase de test, ce qui peut poser des problèmes dans le cas où les paramètres du système dépendent de son niveau d'actionnement et souvent de manière non-linéaire. Cela peut ainsi donner des résultats peu significatifs et donc rendre le réajustement mal adapté.

En outre, elle est peu adaptée lorsque le transducteur piézoélectrique présente un couplage électromécanique fort, car le comportement du transducteur dépend alors de la charge consommatrice qu'il alimente en sortie. Son comportement lors de la phase de test à vide devient donc peu pertinent par rapport à la phase de fonctionnement normal.

En outre, le calcul d'adaptation à partir de la théorie générale de calcul des paramètres de pilotage à partir du comportement du transducteur nécessite des calculs complexes, et donc un DSP ou un processeur puissant, ce qui représente un coût, une complexité, un encombrement et une consommation élevés. Cela est particulièrement problématique quand les paramètres ne sont pas tous connus en raison des variations de l'actionnement.

Des autres exemples de l'art antérieur, sans évaluation d'une harmonique spécifique, sont connus de KR 10-2004-0131005 A et de US 2003 / 0034715 A1. Ceci est également le cas pour la divulgation de WO 2017 / 191436 A1, faisant partie de l'art antérieur au sens de l'art. 54(3) CBE.

Un but de l'invention est de pallier en tout ou partie les inconvénients de l'état de la technique, en particulier tels que décrits ici. Il est recherché en particulier une méthode plus fiable, plus précise, plus rapide, applicable à des dispositifs plus simples et plus compacts, et d'une consommation plus faible. En particulier, il est recherché d'obtenir une adaptation du point de fonctionnement de la façon la plus continue possible, et qui puisse être mise en œuvre par un contrôleur simple tel qu'une simple microcontrôleur ou un processeur simple.

**Exposé de l'invention**

L'invention propose un procédé de pilotage d'un circuit de récolte d'énergie électrique selon la revendication 1, l'énergie électrique étant produite par un transducteur piézoélectrique, lequel réalise un résonateur piézoélectrique sous l'effet de vibrations mécaniques issues d'une source d'excitation mécanique.

Ce circuit de récolte reçoit une tension dite piézo alternative issue dudit transducteur piézoélectrique, pour produire une tension de sortie continue par l'intermédiaire d'un convertisseur, typiquement un convertisseur DC-DC fonctionnant par PWM. Ce convertisseur est piloté au moyen d'au moins un signal de pilotage, typiquement un signal de commande d'un rapport de cycle imposé au convertisseur PWM. Ce signal de pilotage est déterminé et ajusté pour que ce convertisseur présente au sein dudit circuit de récolte une impédance dite résistance équivalente dont la valeur détermine une tension d'une valeur déterminée, typiquement une tension régulée, qui dépend dudit signal de pilotage. Typiquement, par exemple dans le cas de l'alimentation d'un accumulateur, le convertisseur régule la tension à l'entrée de ses bornes.

Selon l'invention, ce procédé comprend au moins une réalisation d'un processus dit d'estimation, par un contrôleur électronique dit de pilotage qui est connecté électriquement et opérationnellement au transducteur piézoélectrique et au convertisseur. Ce processus d'estimation comprend les opérations suivantes :

- détection, par mesure de tension dans une partie du circuit de récolte située entre le transducteur piézoélectrique et le convertisseur, de caractéristiques d'un signal dit piézo produit par la tension piézo, pendant une durée de détection antérieure à un premier instant. Typiquement, cette opération est réalisée par mesure des valeurs instantanées de la tension formant le signal de la tension piézo sous une forme directe, ou possiblement modifiée mais sans déformation.
- à partir desdites caractéristiques détectées, évaluation de l'amplitude d'au moins une harmonique dudit signal piézo, ladite harmonique étant d'un rang supérieur à un ;
- à partir de ladite amplitude et d'une valeur dite de résistance actuelle équivalente produite pendant ladite durée de détection sous l'effet d'une valeur dite actuelle dudit signal de pilotage, calcul d'un ajustement à appliquer au convertisseur, ledit calcul d'ajustement comprenant au moins :

  ◦ un calcul d'une valeur dite de nouvelle résistance équivalente à produire à partir d'un deuxième instant postérieur au premier instant, et/ou
  ◦ un calcul d'une nouvelle valeur de signal de commande à appliquer au convertisseur pour lui faire produire ladite nouvelle résistance équivalente ;

- application d'un signal de commande avec ladite nouvelle valeur au convertisseur.

Le terme de "harmonique" est ici utilisé dans sa définition classique, suivant laquelle l'harmonique "zéro" représente la partie continue du signal, et l'harmonique "un" représente la variation opérant selon la fréquence fondamentale.

Comme on le comprend, et comme illustré par les particularités et exemples exposés ici, l'évaluation de l'amplitude d'une harmonique signifie que l'on détermine une valeur estimée qui représente l'amplitude de cette harmonique déterminée, de façon individuelle c'est à dire en la distinguant du reste du signal.

Cette évaluation d'une harmonique est typiquement calculée en temps réel, comme il est connu de l'homme du métier, sur la base de l'évolution temporelle de la tension piézoélectrique à chaque instant et par rapport à sa valeur à l'échantillon précédent. Elle fournit donc une "estimation" au sens de l'automatique, c'est à dire une valeur approchée de l'harmonique de tension obtenue.

L'évaluation de l'amplitude de "une ou plusieurs harmoniques" porte donc sur l'évaluation d'un sous-ensemble du signal, ledit sous-ensemble étant formé par un nombre fini d'harmoniques. Dans un mode de réalisation préféré, l'étape d'évaluation porte sur une seule harmonique.

Selon une particularité, ce procédé est mis en œuvre :

- sans interruption de production d'énergie, ni ouverture du circuit piézo ; et/ou
- sans mesure du courant ni de la puissance de sortie dans le circuit de la batterie ; et/ou
- sans mémoriser, c'est à dire sans écriture en mémoire au cours du fonctionnement, d'autres valeurs que deux échantillons successifs de la tension piézoélectrique ainsi que l'estimation courante de la valeur d'amplitude de l'harmonique de tension.

Comme on le comprend, ce procédé permet de réaliser une adaptation du circuit de récolte et de son convertisseur pour tenir compte du comportement réel dudit circuit, tel qu'il est constaté pendant son fonctionnement en charge.

Typiquement, le calcul de la nouvelle résistance équivalente comprend une résolution d'un polynôme déterminant la valeur de la puissance électrique fournie par le convertisseur, par une méthode de gradient de type Newton-Raphson mise en œuvre pour maximiser ladite puissance électrique, à partir des paramètres suivants :

- la résistance équivalente $R$ du convertisseur,
- la capacité maximale $C_p$ du transducteur piézoélectrique, et
- le facteur de qualité mécanique $Q$ du transducteur.

En particulier, cette résolution porte sur l'équation suivante :

$$P = \frac{1}{\left(r\Omega + \frac{\pi}{2}\right)^2 k_m^2 \Omega^2} \frac{M\gamma^2 r/\omega_0}{\left(\frac{1}{Q} + \frac{2k_m^2 r}{\left(r\Omega + \frac{\pi}{2}\right)^2}\right)^2 \Omega^2 + \left(1 - \Omega^2 + \frac{k_m^2 r\Omega}{r\Omega + \frac{\pi}{2}}\right)^2}.$$

où $r = RC_p\omega_0$, $\quad \Omega = \dfrac{\omega}{\omega_0} \quad$ et $\quad k_m^2 = \dfrac{\alpha^2}{KC_p}$ ,

et pour un système résonant piézoélectrique de masse $M$, de raideur $K$, de coefficient de couplage électromécanique $\alpha$, de capacité $C_p$, d'amortissement $D$, fixé à une base soumise à un déplacement $y$ de pulsation $\omega$ et de fréquence propre $\omega_0$.

Typiquement, le procédé comprend un processus de pré-caractérisation préalable à la durée de fonctionnement autonome, par exemple mené une seule fois, par exemple et à l'aide d'un ordinateur ou d'un contrôleur de pré-caractérisation différent du contrôleur de pilotage et plus puissant.

Ce processus de pré-caractérisation est agencé selon des méthodes connues pour réaliser une mesure ou un calcul de paramètres du résonateur piézoélectrique qui restent constants pendant la durée de fonctionnement autonome, et en particulier sa masse, sa raideur, son couplage électromécanique, et/ou sa fréquence propre, pour un ou plusieurs niveaux d'excitation. Les valeurs de ces paramètres sont alors stockées dans une mémoire accessible au contrôleur de pilotage. Ce dernier lit ces valeurs au cours du fonctionnement autonome, et optionnellement choisit celles qui correspondent aux paramètres de fonctionnement piézo qu'il détecte, par exemple en fonction du niveau d'excitation constaté.

Selon une particularité, l'étape de détection (51) s'effectue par mesure directe (M11) du signal de tension sous la forme qu'il présente à la sortie du transducteur. De préférence, il s'agit du signal tel quel et non redressé.

Alternativement ou en combinaison, cette mesure peut aussi porter sur une version redressée et/ou amplifiée, mais sans changement de sa forme (ledit non-changement étant défini sur une demi période ou au moins sur un quart de période). Par exemple, dès lors que le circuit comprend un composant qui déforme le signal, comme une filtration par condensateur et/ou un redressement incluant une modification de la forme locale (par exemple par saturation de diodes), une particularité de l'invention prévoit que la mesure de tension de l'étape de détection se fera entre la sortie du transducteur et l'entrée dudit composant.

Plus particulièrement, ce procédé est mis en œuvre dans un circuit de récolte où le convertisseur (123) reçoit la tension piézo (Vp) de façon asynchrone sans commande, directement ou par l'intermédiaire d'un circuit de redressement passif sans commande, notamment par composants directionnels bipolaires tels que des diodes, et par exemple sans utiliser d'interrupteurs commandés.

Selon des particularités avantageuses pouvant être ou non combinées entre elles et avec les précédentes :

- Le convertisseur est un régulateur de tension continue-continue qui fonctionne par modulation de largeur d'impulsion et est commandé par un signal de commande qui représente le rapport cyclique de ladite modulation.
- L'étape de calcul d'ajustement comprend au moins :

  ◦ à partir de l'amplitude d'harmonique calculée et de la valeur de résistance actuelle, un calcul d'une valeur de capacité maximale représentant le fonctionnement du transducteur piézoélectrique au premier instant ;
◦ à partir de ladite capacité maximale et d'une valeur d'un facteur de qualité, calculée ou mémorisée pour ledit transducteur piézoélectrique, un calcul de la nouvelle résistance équivalente.

- L'étape de calcul de la valeur de capacité maximale comprend en outre un calcul d'une valeur de l'amplitude maximale de déplacement, laquelle représente le fonctionnement du transducteur piézoélectrique durant la durée de détection ; et ledit procédé comprend en outre un calcul de la valeur dudit facteur de qualité à partir de l'amplitude maximale de déplacement et d'une valeur d'accélération reçue ou lue dans une mémoire électronique.
- Le procédé comprend en outre une mesure ou une lecture, pendant la durée de détection, d'une valeur d'accélération subie par le transducteur piézoélectrique ; et l'étape de calcul d'ajustement comprend au moins :

  ◦ à partir de l'amplitude d'harmonique calculée et de la valeur de résistance actuelle, un calcul d'une valeur de capacité maximale et d'une valeur maximale de déplacement, lesquelles représentent le fonctionnement du transducteur piézoélectrique durant la durée de détection ;
  ◦ à partir de ladite amplitude maximale de déplacement et de ladite valeur d'accélération, un calcul d'une valeur d'un facteur de qualité représentant le fonctionnement du transducteur piézoélectrique, et
  ◦ à partir de ladite capacité maximale et dudit facteur de qualité, un calcul de la nouvelle valeur de résistance équivalente.

- L'étape d'évaluation d'au moins une harmonique est réalisée au moins par une méthode récursive par les moindres carrés.
- L'étape d'évaluation de l'amplitude porte au moins sur l'amplitude de la troisième harmonique du signal piézoélectrique.
- L'étape d'évaluation de l'amplitude porte uniquement sur l'évaluation d'un ou plusieurs harmoniques de rang supérieur ou égal à trois, et par exemple uniquement d'un rang égal à trois
- Lors d'une évaluation de l'harmonique de rang trois, les étapes de calcul de la capacité du transducteur piézoélectrique et du facteur de qualité sont réalisées par résolution du système suivant d'équations :

$$\begin{cases} C_p = \dfrac{\pi(\,4V_{sat} - 3a_3\pi\,)}{6a_3\pi R\omega} \\ x_m = \dfrac{V_{sat}}{\omega R\alpha}\left(\omega R C_p + \dfrac{\pi}{2}\right) \end{cases}$$

- Lors d'une évaluation de l'harmonique de rang un, en tant qu'exemple ne faisant pas partie de l'invention, les étapes de calcul de la capacité du transducteur piézoélectrique et du facteur de qualité sont réalisées par résolution, en fonction de la variable Cp, du système suivant d'équations :

$$V_{sat}\dfrac{\sqrt{8C_p\pi R\omega - 4\sqrt{2\pi}\sqrt{(C_p R\omega)(\pi - 2C_p R\omega)\mathrm{ArcCos}\left[-1 + \frac{2\pi}{\pi + 2C_p R\omega}\right] + (\pi + 2C_p R\omega)^2 \mathrm{ArcCos}\left[-1 + \frac{2\pi}{\pi + 2C_p R\omega}\right]^2}}}{2C_p\pi R\omega} = a_1$$

- Le procédé de pilotage comprend, pendant une durée de fonctionnement autonome, une pluralité d'itérations comprenant chacune :

  ◦ le processus d'estimation ;
  ◦ un processus d'ajustement, dit asservissement, comprenant une application au convertisseur de la nouvelle valeur de signal de commande issue dudit processus d'estimation, notamment selon une évolution progressive gérée selon un processus de correction de type proportionnel ou proportionnel-intégral ; et
  ◦ un processus dit de fonctionnement nominal, pendant lequel le contrôleur électronique est maintenu en mode veille tout en continuant à alimenter le convertisseur avec ladite nouvelle valeur de signal de commande.

De préférence, comme exposé et illustré ici, l'évaluation d'harmonique fournit une évaluation d'une seule harmonique. Alternativement, elle peut comprendre une évaluation individuelle de plusieurs harmoniques.

Optionnellement, le procédé peut aussi utiliser une étape d'évaluation d'harmonique portant sur plusieurs harmoniques formant un sous-ensemble du signal, c'est à dire un nombre fini d'harmoniques. Ces harmoniques peuvent être évaluées dans leur ensemble, ou être évaluées individuellement pour une utilisation séparée.

Selon un autre aspect, l'invention propose un dispositif de pilotage d'un circuit de récolte d'énergie électrique selon la revendication 13, l'énergie électrique étant produite par un transducteur piézoélectrique, lequel réalise un résonateur piézoélectrique sous l'effet de vibrations mécaniques issues d'une source d'excitation mécanique.

Ce circuit de récolte reçoit une tension dite piézo alternative issue dudit transducteur piézoélectrique, pour produire une tension de sortie continue par l'intermédiaire d'un convertisseur, lequel est piloté au moyen d'au moins un signal de pilotage pour présenter au sein dudit circuit une impédance dite résistance équivalente dont la valeur détermine une tension d'opération du convertisseur d'une valeur qui dépend dudit signal de pilotage.

Cette tension d'opération est par exemple une tension d'entrée, lorsque la sortie est connectée à une batterie à tension constante.

Ce dispositif comprend un contrôleur électronique de pilotage programmé pour mettre en œuvre toutes les étapes du procédé de pilotage tel qu'exposé ou revendiqué ici.

Selon une particularité, l'invention propose un circuit de récolte d'énergie électrique venant d'un résonateur piézoélectrique, ainsi qu'un dispositif de génération d'énergie électrique comprenant un tel circuit de récolte d'énergie électrique et un résonateur piézoélectrique alimentant ledit circuit. Ce circuit est d'un type comprenant au moins :

-	un étage redresseur connecté pour recevoir une tension piézo alternative, formant un signal piézo, de la part dudit résonateur piézoélectrique et produisant une tension redressée ;
-	optionnellement, un dispositif de stockage intermédiaire d'énergie électrique recevant la tension redressée ;
-	un convertisseur régulé pilotable fournissant une tension de sortie,

Selon cette particularité, ledit circuit de récolte d'énergie électrique comprend un dispositif de pilotage tel qu'exposé ci-dessus, qui est connecté pour mesurer ledit signal piézo et piloter ledit convertisseur.

Plus particulièrement, le convertisseur de ce circuit de récolte est réalisé par au moins un convertisseur continu-continu fonctionnant par hachage et qui est piloté en modulation de largeur d'impulsion.

Selon encore un autre aspect, l'invention propose un dispositif de génération d'énergie électrique comprenant un circuit de récolte d'énergie électrique tel qu'exposé ici, et un résonateur piézoélectrique alimentant ledit circuit de récolte. Ce dispositif est caractérisé en ce qu'il comprend en outre au moins un accéléromètre agencé pour mesurer une accélération produite par la source d'excitation ; en ce que le contrôleur de pilotage dudit circuit de récolte est connecté pour recevoir ladite mesure d'accélération ; et en ce que ledit contrôleur est agencé pour mettre en œuvre toutes les étapes d'un procédé de pilotage tel qu'exposé ici.

Encore selon un autre aspect, l'invention propose un dispositif électrique ou électronique comprenant un tel dispositif de génération d'énergie électrique, qui est agencé pour lui fournir une alimentation électrique autonome ou un complément d'alimentation électrique, sous l'effet d'une excitation mécanique en vibration fournie par l'environnement matériel dudit dispositif électrique ou électronique.

A la différence des méthodes adaptatives connues utilisant une détection du fonctionnement du transducteur, la méthode de l'invention ne nécessite pas de modifier ni de perturber le régime de fonctionnement du système pendant la phase de test. Elle est ainsi plus fiable et plus précise. Elle est basée sur une mesure en temps réel portant sur le fonctionnement opérationnel du transducteur, et est mieux applicable à des résonateurs piézoélectriques à fort couplage électromécanique.

L'invention permet d'assurer un transfert maximal de puissance depuis une source d'énergie acoustique d'accélération variable vers un composant de stockage tel qu'une batterie, quelle que soit l'évolution du signal d'accélération.

Elle permet au circuit de récolte de s'adapter automatiquement aux variations de l'amplitude et de la fréquence de l'accélération fournie par la base vibrante.

Elle lui permet de s'adapter automatiquement aux variations de certains paramètres du système.

Elle a en outre l'avantage de nécessiter une quantité de calculs et une capacité de traitement de signal suffisamment faibles pour permettre l'utilisation d'un microcontrôleur simple, donc basse consommation et de faibles coût et encombrement.

A titre d'exemple, il peut suffire qu'il soit muni d'un convertisseur analogique-numérique et d'un générateur à modulation de largeur d'impulsion PWM, ce qui est le cas de la quasi-totalité des microcontrôleurs présents sur le marché.

Dans le cas où les fluctuations de l'amplitude et de la fréquence de l'accélération sont lentes par rapport à la période de ces oscillations, il est en outre possible de ne réaliser les calculs d'adaptation que lors de courtes phases de test, et ainsi de désactiver ou mettre en veille le contrôleur.

Par exemple, en comparaison avec le document US2015263643, l'invention permet de réaliser moins de calcul, et de nécessiter moins de mémoire, permettant ainsi un dispositif plus simple, plus fiable et moins coûteux, en particulier pour exploiter des transducteurs à fort couplage. En particulier, la technologie mise en oeuvre dans ce document utilise plusieurs mesures pour maximiser la puissance (la tension filtrée et la puissance de sortie), alors que l'invention permet de se contenter d'une seule mesure de tension non déformée. La prise en compte de ces mesures multiples, et l'asservissement qui en découle, nécessitent par exemple des capacités de calcul et de mémoire conséquentes, qui représentent une complexité et des contraintes que l'invention permet d'éviter ou de limiter.

Des modes de réalisation variés de l'invention sont prévus, intégrant selon l'ensemble de leurs combinaisons possibles les différentes caractéristiques optionnelles exposées ici.

### Liste des figures

D'autres particularités et avantages de l'invention ressortiront de la description détaillée d'un mode de mise en œuvre nullement limitatif, et des dessins annexés sur lesquels :

- la FIGURE 1 est un schéma symbolique qui illustre un dispositif autonome selon un exemple de mode de réalisation de l'invention ;
- la FIGURE 2 est un schéma symbolique qui illustre un dispositif d'alimentation selon un exemple de mode de réalisation de l'invention ;
- la FIGURE 3 est un diagramme fonctionnel qui illustre un procédé de pilotage selon un exemple de mode de réalisation de l'invention ;
- la FIGURE 4 est un graphique de simulation qui illustre, l'évolution dans le temps de différents paramètres de fonctionnement du dispositif d'alimentation selon un exemple de mode de réalisation de l'invention, avec :

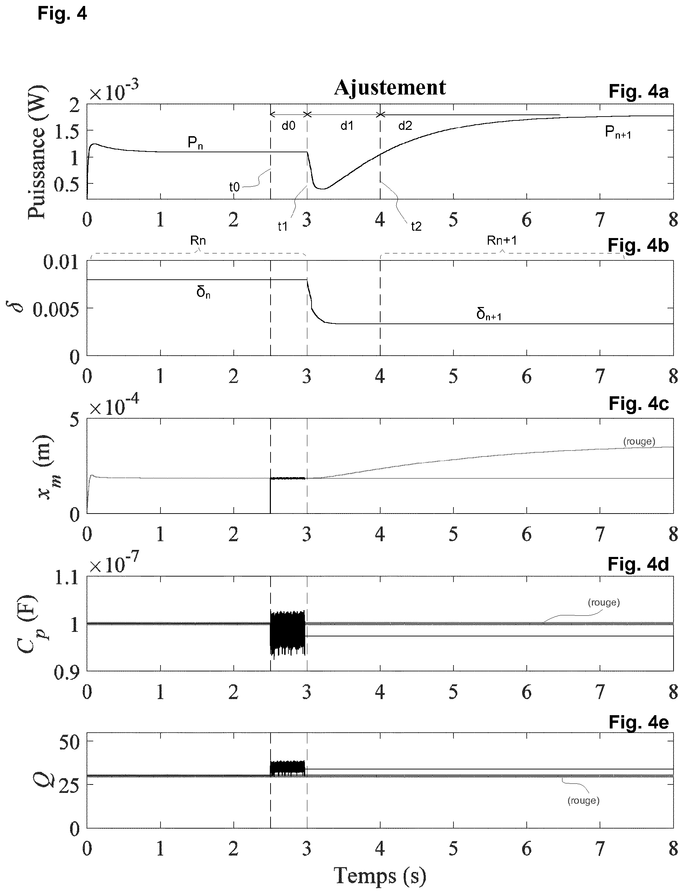

  ◦ en FIGURE 4a, la puissance produite,
  ◦ en FIGURE 4b, le rapport cyclique commandé au convertisseur,
  ◦ en FIGURE 4c, l'amplitude maximale de mouvement du transducteur piézoélectrique, telle que calculée par le contrôleur,
  ◦ en FIGURE 4d, la capacité équivalente du transducteur piézoélectrique, telle que calculée par le contrôleur,
  ◦ en FIGURE 4e, le facteur de qualité mécanique du transducteur piézoélectrique, telle que calculée par le contrôleur ;

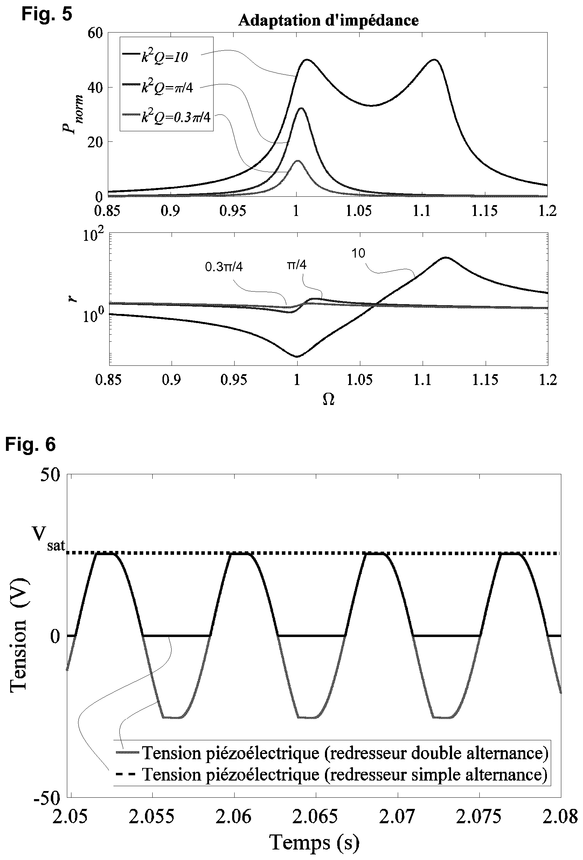

- la FIGURE 5 est un graphique d'adaptation d'impédance qui représente, pour un dispositif d'alimentation avec générateur piézoélectrique piloté pour produire la puissance optimale :

  ◦ en haut, l'évolution de la puissance électrique normalisée produite, et
  ◦ en bas, l'évolution de la valeur résistance équivalente normalisée qui est commandée pour le convertisseur ;

- la FIGURE 6 est un graphique qui représente la tension piézoélectrique et la tension redressée en entrée du convertisseur d'un dispositif d'alimentation selon un exemple de mode de réalisation de l'invention, pour un étage redresseur à double alternance et un étage redresseur à simple alternance.

### Description d'un exemple de mode de réalisation

L'invention permet d'assurer un transfert maximal de puissance depuis une source d'énergie acoustique d'accélération variable vers un stockage, tel qu'une batterie, quelle que soit l'évolution du signal d'accélération. L'intérêt de l'invention est multiple. Elle permet au dispositif :

- de s'adapter automatiquement aux variations de l'amplitude $\gamma$ et de la fréquence de l'accélération fournie par la base vibrante 100, et donc aux variations de l'amplitude $x_m$ et de la fréquence du transducteur. La seule hypothèse consiste à supposer que les fluctuations de l'amplitude et de la fréquence de l'accélération sont lentes par rapport à la période des oscillations du résonateur,
- de s'adapter automatiquement aux variations de certains paramètres du système, prévisibles ou non, qui pourraient influer sur son fonctionnement,
- de nécessiter une quantité de calcul et de traitement de signal suffisamment faible pour qu'il suffise d'utiliser un microcontrôleur simple, donc avec une basse consommation électrique, dès lors qu'il est muni d'un convertisseur analogique-numérique et d'un générateur PWM, ce qui est le cas de la quasi-totalité des microcontrôleurs présents sur le marché.

La combinaison de ces possibilités va au delà d'une simple amélioration de certaines performances dans une application existante, et donne un ensemble cohérent qui permet de nombreuses applications nouvelles.

Dans son fonctionnement normal, c'est à dire en exploitation, le procédé de pilotage comprend une répétition d'itérations d'un cycle de phases réalisant des processus différents. Ces itérations sont déclenchées par exemple par une horloge, et/ou à réception de signaux extérieurs spécifiques tels que des capteurs d'environnement ou des commandes venant de systèmes ou dispositifs extérieurs.

Chaque itération au sein de ce fonctionnement normal se déroule typiquement en trois temps. Une première phase consiste à estimer les paramètres en régime permanent. La deuxième phase consiste à commander la résistance de charge du convertisseur DC-DC (via le rapport cyclique qui lui est demandé par le signal de commande) à la valeur de la résistance optimale correspondant à ces paramètres estimés dans la première phase. La dernière phase constitue une phase de fonctionnement nominal, pendant laquelle le signal PWM appliqué au convertisseur est maintenu à l'identique, et où les paramètres du système et l'accélération sont supposés invariants.

## Description du dispositif et du procédé

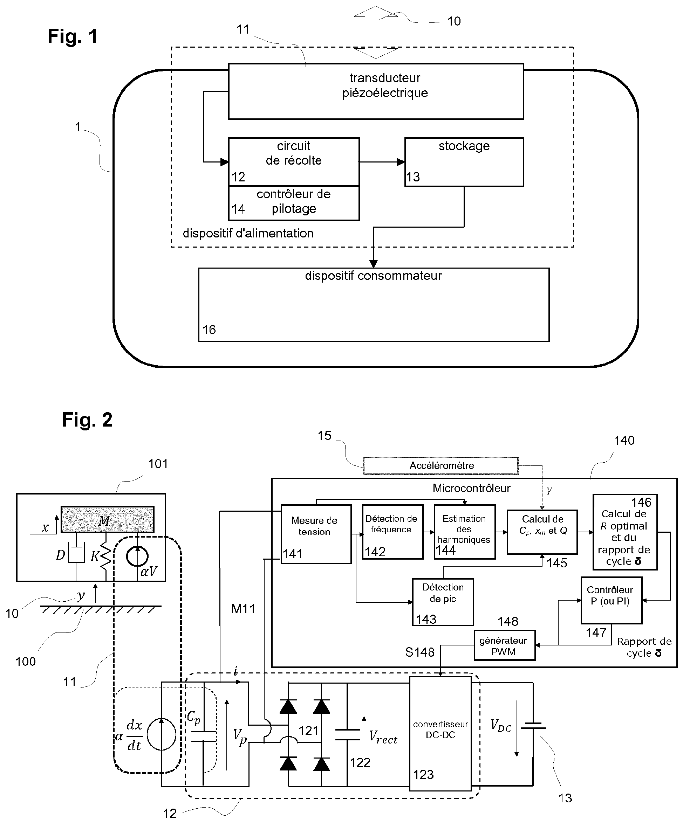

Dans l'exemple illustré en FIGURE 2, la conversion électromécanique est réalisée par un résonateur 101 incluant un transducteur piézoélectrique 11 . Le résonateur 101 est actionné par la vibration 10 d'une base vibrante 100, ici selon une dimension "y". Cette vibration provoque dans le résonateur une oscillation, ici selon une dimension "x", qui produit une déformation mécanique du transducteur piézoélectrique 11.

Cet exemple illustre un résonateur linéaire à un seul degré de liberté, qui est particulièrement simple à mettre en œuvre et à modéliser. Mais l'invention peut tout à fait s'appliquer à la récolte d'énergie à partir de sources différentes et/ou par un ou des résonateurs de types différents voire plus complexes.

Le transducteur piézoélectrique 11 est branché sur un système redresseur 121 à pont de diodes et un condensateur de lissage 122. Le transfert d'énergie depuis le condensateur de lissage est ensuite assuré par un système 123 de conversion DC-DC commandé par signal agissant en Pulse Width Modulation (PWM), par exemple de type hacheur, dont l'interrupteur est commandé par un signal S148 délivré par un microcontrôleur 140.

Dans ce système, on remarque que l'ajustement du signal de commande S148 de l'interrupteur est rendu possible par la seule mesure d'une unique tension, à savoir la tension Vp aux bornes du résonateur piézoélectrique 101.

Dans cet exemple, à titre optionnel, le microcontrôleur 140 est aussi connecté à un accéléromètre 145 qui détecte en temps réel les accélérations se produisant dans la base vibrante ou dans le résonateur.

La FIGURE 2 représente symboliquement le dispositif complet 1, dans une représentation fonctionnelle, mais le dispositif réel peut comporter des fonctions ou circuits supplémentaires, et/ou réaliser certaines fonctions ou composants sous la forme de circuits équivalents.

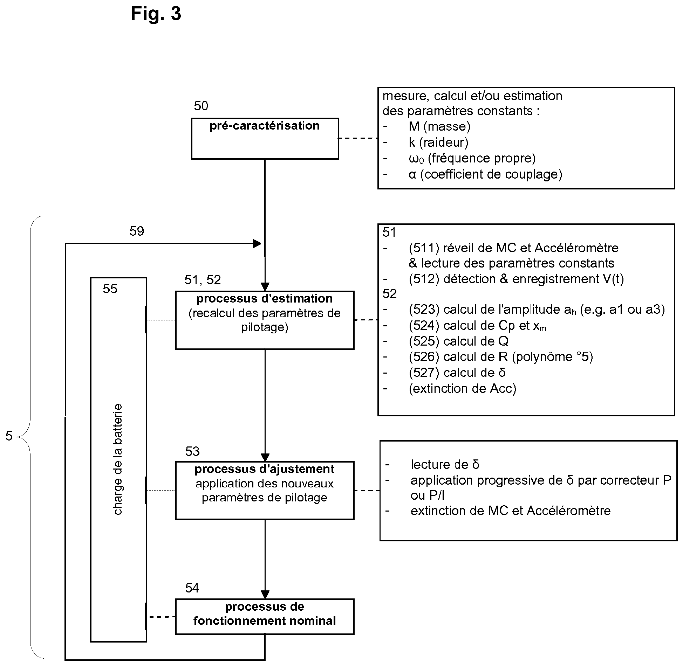

La FIGURE 3 représente schématiquement les principales étapes exécutées par le microcontrôleur 140 qui réalise le contrôleur de pilotage 14 du dispositif 14.

Un certain nombre de paramètres du dispositif et/ou du résonateur sont déterminés dans une phase de pré-caractérisation 50, qui est préalable à l'utilisation nominale 54 du dispositif 1, par exemple à la conception du dispositif ou lors d'une phase de calibration et selon des méthodes connues.

Chaque itération 59 réalise un cycle qui comprend, dans cet ordre ou dans un autre :

- un processus d'estimation, incluant une phase de détection 51 et une phase de calcul 52 de nouveaux paramètres ;
- suivi d'un processus d'ajustement 53 où les nouveaux paramètres sont appliqués au convertisseur 123 ; et
- un processus de fonctionnement nominal de production et charge, qui représente en générale la majorité du cycle.

Comme on le voit, la production d'énergie et la charge 55 de la batterie et/ou l'approvisionnement des consommateurs sont poursuivis pendant toutes les étapes du procédé, y compris le processus d'estimation 51, 52 et le processus d'ajustement 53. De préférence, cette production d'énergie et approvisionnement 55 sont ainsi réalisés de façon continue pendant la totalité de ce fonctionnement normal 5, sans aucune interruption de la production d'énergie.

La FIGURE 4 illustre l'évolution dans le temps de différents paramètres de fonctionnement du dispositif d'alimentation :

- la puissance produite en sortie du convertisseur 123 ;
- le rapport cyclique $\delta$ commandé au convertisseur 123 ;
- l'amplitude maximale $x_m$ de mouvement du résonateur piézoélectrique, telle que calculée 524 par le contrôleur 14, 145 ;
- la capacité équivalente Cp du transducteur piézoélectrique 11, telle que calculée 524 par le contrôleur 14, 145 ; et
- le facteur de qualité mécanique Q du transducteur piézoélectrique, telle que calculée 525 par le contrôleur 14, 145, dans le cas où le contrôleur dispose de la valeur "$\gamma$" de l'accélération.

Cette figure représente un fonctionnement qui n'inclue qu'un seul ajustement.

Jusqu'à l'instant t1 (t=3s), le dispositif fonctionne de façon nominale, c'est à dire sans changement de ses paramètres de commande, avec une valeur $\delta n$ du rapport de cycle, fournissant une résistance équivalente $R_n$.

Pendant la durée de détection d0, à partir de l'instant t0 (t=2,5s) et jusqu'à t1, le contrôleur 14 réalise la phase de détection 51 : il réveille 511 le microcontrôleur 140 et l'accélérateur 15, puis il lit et enregistre 512 les paramètres de tension Vp et d'accélération $\gamma$.

Pendant la durée d1, entre t1 et t2 (t=4s), le contrôleur 14 applique progressivement la nouvelle valeur $\delta n+1$ de rapport de cycle au convertisseur 123. Dans cet exemple, le signal S148 de commande est modifié progressivement, ici à l'aide d'un contrôleur 147 fonctionnant en mode proportionnel ou proportionnel-intégral réalisant un asservissement progressif pour arriver à la nouvelle valeur $\delta_{n+1}$ du rapport cyclique $\delta$, produisant ainsi la nouvelle valeur $R_{n+1}$ de la résistance équivalente.

A partir de t2, le contrôleur de pilotage 14 est mis en veille et ne fournit plus que le signal de commande S148 au convertisseur 123, et le dispositif fonctionne de façon nominale sans modification de ce paramètre pendant la durée d2.

Comme on le voit en FIGURE 2, le microcontrôleur 140 ne nécessite que deux connexions : une mesure M11 de la tension Vp instantanée aux bornes du transducteur piézoélectrique 12, de préférence mais non nécessairement avant le redresseur 121 ; et l'envoi d'un signal de commande S148 au convertisseur 123 pour commander son impédance en fonction de l'ajustement calculé par le microcontrôleur 140.

Au sein du microcontrôleur 140, la mesure de la tension instantanée Vp est effectuée par un bloc ou module de mesure de tension 141. Ce bloc de mesure 141 transmet l'état instantanée de cette tension à :

- un bloc 142 de détection de fréquence, qui détermine la fréquence à laquelle cette tension instantanée Vp oscille, et
- un bloc 143 de détection de pic, qui détermine l'instant exact où se produit le maximum de cette tension Vp.

Le bloc de détection de fréquence 142 transmet ses résultats à un bloc 144 d'estimation des harmoniques, qui évalue l'amplitude des oscillations de la tension Vp pour une harmonique (ou plusieurs) de sa fréquence de base.

A partir des résultats du bloc d'estimation des harmoniques 144 et des résultats du bloc de détection de pic 143, et des valeurs de certaines grandeurs préalablement mémorisées pour le dispositif 1, le microcontrôleur 140 réalise un calcul 51, 52 d'estimation des paramètres qui doivent être utilisés par le convertisseur 123 lors de la prochaine période nominale de fonctionnement.

Ce calcul d'estimation 51, 52 est par exemple réalisé par un premier bloc de calcul 145 connecté opérationnellement avec un deuxième bloc de calcul 146.

Le premier bloc de calcul 145 reçoit les résultats du bloc d'estimation des harmoniques 144 et du bloc de détection de pic 143, ainsi que la valeur "$\gamma$" (gamma) de l'accélération, qui est détectée dans la partie mécanique du résonateur par un accéléromètre 15 intégré au dispositif 1. Optionnellement, cette valeur est lue dans une mémoire où a été stockée une valeur typique pour moyenne de cette accélération, ou une valeur lue ou estimée par un autre dispositif connecté au dispositif.

Par exemple, ce premier bloc de calcul 145 réalise les opérations de calcul 523 de l'amplitude $a_h$ de l'harmonique concernée selon l'invention, calcul 524 de la capacité du transducteur 11 pendant la période de détection, et calcul 525 du facteur de qualité mécanique Q.

A partir de ces éléments, le deuxième bloc de calcul 146 réalise le calcul de la valeur optimisée de la résistance équivalente Rn+1 qui sera visée pour le convertisseur 123 pendant la prochaine période de fonctionnement nominal 54, et la valeur $\delta n+1$ du rapport de cycle qui sera utilisée comme signal de commande S148 pour atteindre cette valeur de résistance équivalente.

**Modélisation**

Comme illustré en FIGURE 2, le modèle de résonateur utilisé est celui d'un système résonant piézoélectrique à un degré de liberté, de masse *M*, de raideur *K*, de coefficient de couplage électromécanique $\alpha$, de capacité $C_p$, d'amortissement *D*, fixé à une base soumise à un déplacement *y* de pulsation $\omega$. Avec ces notations, Le comportement du système est donc décrit par l'équation (1) :

$$\begin{cases} \dfrac{d^2x}{dt^2} + \dfrac{\omega_0}{Q}\dfrac{dx}{dt} + \omega_0^2 x + \dfrac{\alpha}{M}V = \dfrac{d^2x}{dt^2} \\ i = \alpha\dfrac{dx}{dt} - C_p\dfrac{dV}{dt} \end{cases} . \qquad (1)$$

Le déplacement du résonateur est noté $x = x_m \sin(\omega t)$. On suppose que les valeurs des paramètres *M, K* et $\alpha$ du résonateur sont connues (par exemple mémorisées sous forme de tables après la phase de pré-caractérisation 50), mais que le facteur de qualité $Q$ et la capacité $C_p$ du dispositif sont inconnus et peuvent varier dans le temps. L'accélération est ici mesurée via un accéléromètre 15.

Principe de l'ajustement

En considérant que le convertisseur DC-DC 123 se comporte comme une résistance $R$ équivalente, la puissance récupérée s'écrit :

$$P = \frac{1}{\left(r\Omega + \frac{\pi}{2}\right)^2 k_m^2 \Omega^2} \cdot \frac{M\gamma^2 r / \omega_0}{\left(\frac{1}{Q} + \frac{2k_m^2 r}{\left(r\Omega + \frac{\pi}{2}\right)^2}\right)^2 \Omega^2 + \left(1 - \Omega^2 + \frac{k_m^2 r\Omega}{r\Omega + \frac{\pi}{2}}\right)^2} \tag{2}$$

où $r = RC_p\omega_0$, $\quad \Omega = \dfrac{\omega}{\omega_0} \quad$ et $\quad k_m^2 = \dfrac{\alpha^2}{KC_p}$ .

Dans la suite, on utilisera également le coefficient de couplage $k^2 = \dfrac{k_m^2}{1+k_m^2}$

A partir de l'équation (2), on peut montrer que la résistance optimale dépend de $\omega_0$, de $\omega$, de $k_m^2$ et de $Q$. Elle ne dépend pas de l'accélération $\gamma$, et ne dépend pas directement de l'amplitude du déplacement $x_m$.

La FIGURE 5 représente, sur le graphique du haut, l'évolution de la puissance maximale (normalisée par rapport à $\dfrac{M\gamma^2}{8\omega_0}$), obtenue pour une adaptation d'impédance optimale pour chaque fréquence ($r = r_{opt}(\Omega)$ )et, pour un facteur de qualité $Q = 100$. Cette évolution est ici illustrée par trois courbes, correspondant à trois niveaux de couplage différents, avec $k^2Q = 10$, $k^2Q = \pi/4$, et $k^2Q = 0.3\pi/4$.

Le graphique du bas représente la résistance normalisée équivalente correspondant à ces valeurs de puissance récupérée.

La résistance optimale ne dépend pas de l'accélération ni de l'amplitude du déplacement mais seulement des paramètres $\omega_0$, $k_m^2 = \alpha C_p / M\omega_0^2$ et $Q$. Comme on suppose que $\omega_0$ et $\alpha$ sont connus, il suffit donc de déterminer $C_p$ et $Q$. Pour que le système s'ajuste en un suivi du point de puissance maximale (MPPT), il suffit de résoudre le polynôme donnant la résistance optimale. On peut ensuite en déduire le rapport cyclique optimal du signal PWM de contrôle du convertisseur DC-DC, par exemple un hacheur buck-boost via :

$$\delta = \sqrt{\frac{L\omega}{R\pi}}$$

Pour estimer les paramètres $C_p$ et $Q$, l'asservissement se base sur la mesure de la tension piézoélectrique et l'estimation en temps réel de la troisième harmonique du signal de tension piézoélectrique.

La FIGURE 6 illustre la forme du signal $V$ (Vrect) obtenu en sortie du redresseur 121, pour un redresseur de type double alternance (comme illustré en FIGURE 2) ou de type simple alternance.

Harmonique un

Selon la théorie générale, et en utilisant le processus d'estimation selon l'invention, il est possible d'estimer le mouvement du résonateur à partir de :

- la moyenne du signal $V$ pour un redresseur simple alternance, ou
- le premier harmonique du signal de tension $\tilde{V}$ pour un redresseur double alternance.

Cette méthode nécessiterait de résoudre une équation non-linéaire sans solution évidente, à chaque pas d'itération.

Dans un tel mode de réalisation, et dans le cas d'un redresseur double, le processus d'estimation comprend une opération de résolution numérique pour trouver le paramètre Cp, dans laquelle chaque pas de calcul résout l'équation suivante (avec comme inconnue Cp) :

$$\frac{V_{sat}\sqrt{8C_p\pi R\omega - 4\sqrt{2\pi}\sqrt{(C_pR\omega)(\pi - 2C_pR\omega)\mathrm{ArcCos}\left[-1 + \frac{2\pi}{\pi + 2C_pR\omega}\right] + (\pi + 2C_pR\omega)^2\mathrm{ArcCos}\left[-1 + \frac{2\pi}{\pi + 2C_pR\omega}\right]^2}}}{2C_p\pi R\omega} = a_1 \quad (3)$$

où $a_1$ est l'amplitude du premier harmonique du signal de la tension piézoélectrique et où $R$ est la valeur de la résistance au moment de la mesure.

Ce calcul donne un résultat précis, qui permet d'adapter le point de fonctionnement à l'évolution du comportement réel du transducteur en condition d'exploitation.

Il est proposé par les inventeurs pour réaliser un système adaptatif, plus particulièrement dans une configuration où une puissance de calcul importante est disponible.

Harmonique trois

Cependant, la relation entre ces grandeurs et le déplacement du résonateur est très complexe pour l'harmonique un, et cette opération génère des calculs lourds, qui sont incompatibles avec l'utilisation de microcontrôleurs basse consommation.

En revanche, les inventeurs ont déterminé que la relation entre le déplacement du résonateur et certains harmoniques de rang plus élevé est linéaire et très simple. Ces relations peuvent être trouvées à partir de l'équation (1) et des formes d'ondes décrites sur la FIGURE 6.

A titre d'exemple, et dans un mode de réalisation actuellement préféré, dans le cas d'un calculateur de faible puissance et consommation ils proposent d'utiliser le 3e harmonique de la tension piézoélectrique.

Ainsi, dans le cas d'un redresseur double alternance, on trouve :

$$\begin{cases} C_p = \dfrac{\pi(4V_{sat} - 3a_3\pi)}{6a_3\pi R\omega} \\ x_m = \dfrac{V_{sat}}{\omega R\alpha}\left(\omega R C_p + \dfrac{\pi}{2}\right) \end{cases} \quad (4)$$

où $a_3$ est l'amplitude du 3e harmonique de la tension piézoélectrique.

Avec un harmonique de rang strictement supérieur à un, et par exemple de rang trois, cette méthode permet alors d'obtenir une estimation du mouvement du résonateur (en amplitude et en fréquence) via une expression explicite simple qui nécessite un minimum de calculs. A partir de l'estimation de ce mouvement, combinée à la connaissance de la fréquence propre $\omega_0$ (déterminée lors de la pré-caractérisation 50) et de la mesure de l'accélération, on peut ensuite estimer le facteur de qualité, puis calculer la résistance optimale et donc le rapport cyclique à imposer au convertisseur DC-DC pour obtenir une adaptation d'impédance optimale.

De préférence, la procédure d'estimation des harmoniques utilisée est une méthode récursive par moindres carrés, par exemple telle que décrite dans la publication K. H. Youssef A. El Zawawi and O. A. Sebakhy, "Recursive Least Squares Harmonic Identification in Active Power Filters," in Proceedings of the European Control Conference, Kos (Greece), 2007.

Cette procédure présente l'avantage de nécessiter à la fois peu de calculs et peu de mémoire, lesquelles sont des contraintes fortes dans le cas d'utilisation de microcontrôleurs pour réaliser le contrôleur de pilotage 14. Le choix de cette procédure d'estimation est un exemple, et d'autres méthodes d'estimations d'harmoniques peuvent aussi être utilisées.

L'exemple de mode de réalisation décrit ici utilise un pont redresseur 121 à quatre diodes, fournissant une double alternance.

Cependant, indépendamment des autres particularités optionnelles de l'invention, il est aussi prévu d'utiliser un circuit à simple alternance. Il présente par exemple l'avantage de limiter l'encombrement, et de fournir un meilleur rendement électrique à bas niveau de tension.

Dans certains modes de réalisation, le circuit redresseur est à double alternance mais le microcontrôleur 140 est d'un type comprenant un convertisseur analogique-numérique 141 limité à la mesure de tensions positives, comme c'est souvent le cas pour les microcontrôleurs à basse consommation.

Dans ce cas, la forme d'onde de la tension piézoélectrique mesurée par le microcontrôleur est identique à celle obtenue pour un redresseur simple alternance, avec pour seule différence de présenter une tension de seuil $2V_d$ au lieu de $V_d$. Ceci ne gêne pas l'identification des caractéristiques des oscillations de la tension $V_p$.

On notera que d'autres harmoniques de rang plus élevé que trois sont aussi utilisables dans le cadre de l'invention, en adaptant la résolution aux équations correspondant à l'harmonique choisi.

<u>Calcul du rapport cyclique optimal de contrôle du convertisseur DC-DC</u>

La résistance optimale équivalente à commander au convertisseur DC-DC 123 peut être trouvée en résolvant en polynôme de degré 5, dont une seule racine est réelle et positive. Ce polynôme est obtenu au numérateur en dérivant l'équation (2) par rapport à "r".

La résolution n'a besoin d'être réalisée qu'une seule fois, à l'instant où l'estimation du déplacement maximal $x_m$ a convergé.

Ce polynôme dépend du coefficient de couplage $k_m^2(x_m)$, du facteur de qualité mécanique $Q(x_m)$, et du ratio entre la fréquence des oscillations et la fréquence propre du résonateur $\omega/\omega_0(x_m)$.

Une pré-caractérisation 50 du résonateur 101 permet de déterminer la valeur de ces coefficients pour différents niveaux d'excitation, et ces résultats sont ensuite connus par le système 14, par exemple mémorisés en tables ou restitués par une loi simple déterminée de façon empirique.

Lors de la phase de calcul d'estimation 526, 527, le contrôleur 14 choisit alors pour ces coefficients la valeur connue qui correspond à l'amplitude $\widehat{x_m}$ obtenue lors du calcul d'estimation 524 de l'itération précédente.

La résolution 526 du polynôme peut se faire avec une simple méthode de gradient (par exemple de type Newton-Raphson). Une fois ce calcul réalisé, le rapport cyclique optimal peut être alors être déterminé 527.

Ensuite, par exemple en passant par un correcteur 147 proportionnel (ou proportionnel-intégral), le signal de commande S148 appliqué au convertisseur 123 est modifié pour obtenir que le rapport cyclique $\delta$ converge et s'ajuste à cette nouvelle valeur $\delta$n+1, ce qui permet d'obtenir à nouveau la puissance maximale récupérable.

Dans cet exemple, on a choisi une capacité de lissage 122 de $1\mu$F. On constate sur ces graphiques un régime transitoire puis une stabilisation au point de fonctionnement optimal pour cette fréquence d'oscillation.

A l'instant t2, une fois le rapport cyclique voulu atteint, le microcontrôleur 140 est arrêté, hormis la sortie PWM 148 qui commande le convertisseur DC-DC 123.

Le réveil 511 pour une nouvelle procédure d'ajustement 51, 52, 53 peut être opéré par exemple à une fréquence choisie par le concepteur, qui dépend de l'application visée.

<u>Résultats de simulation</u>

La FIGURE 4 représente des résultats de simulations de régime transitoire (effectuées sous MATLAB/Simulink) démontrant la faisabilité de l'ajustement, qui peut ainsi être qualifié d'asservissement à un point de puissance maximale. La FIGURE 4c illustre l'évolution de l'amplitude de déplacement estimée $x_m$, après le démarrage de l'algorithme pour un résonateur de caractéristiques $M = 3mg$, $Q = 30$, $k^2 = 0.2$, $C_p = 100nF$ et $f_0 = 100Hz$, une accélération de 10m.s$^{-2}$ à la fréquence $f = f_0\sqrt{1 + \frac{k_m^2}{2}}$ et un rapport cyclique fixé initialement à $\delta = 8.10^{-3}$. La capacité de lissage 122 est fixée à $10\mu$F. Le gain du correcteur proportionnel est fixé à $10^{-4}$.

Comme illustré en FIGURE 4b, le processus d'ajustement 53 réalisée entre t1 et t2 amène progressivement le rapport cyclique à une nouvelle valeur $\delta = 3,391.10^{-3}$, qui a été calculée en 527 pendant le processus d'estimation 52.

Dans les FIGURE 4c à FIGURE 4e, la courbe en rouge représente la valeur réelle, tandis que la courbe en noir représente la valeur estimée telle que calculée pendant le processus d'estimation 52, en 524 pour les paramètres $x_m$ et Cp et en 525 pour le paramètre Q.

Pendant la période initiale jusqu'à $t_0$, cette simulation démarre avec un régime de fonctionnement sous-optimal, c'est à dire avec un rapport cyclique qui n'est pas adapté pour avoir le max de puissance. Dans cette simulation, les valeurs utilisées pour les paramètres $x_m$ et Cp pendant la période initiale (jusqu'à $t_0$) sont supposées être des estimations parfaites, c'est à dire égales à la valeur réelle. La courbe rouge se superpose donc à la courbe noire sur cette période.

A l'instant $t_0$, le contrôleur 14 lance une procédure d'estimation 51, 52 qui se termine à $t_1$.

A l'instant $t_1$, lorsque le processus d'estimation 52 se termine, les nouvelles valeurs estimées pour $x_m$ et Cp sont

mémorisées et ne seront plus recalculées jusqu'à la prochaine période d'estimation.

La courbe noire est donc constante à partir de $t_1$, et on voit les erreurs d'estimation en regardant l'écart entre les courbes noires et les courbes rouges.

A partir de t1, on garde en mémoire les estimations puis on modifie 53 le rapport cyclique $\delta$ jusqu'à a nouvelle valeur $\delta_{n+1}$ déterminée par l'algorithme.

Comme on le voit en FIGURE 4c, par contre, la valeur réelle calculée par la simulation pour l'amplitude $x_m$ augmente progressivement après $t_1$ pour se stabiliser à une valeur plus élevée. L'amplitude de déplacement varie parce qu'on change le rapport cyclique, donc la résistance équivalente de la charge, donc la tension piézoélectrique. Du fait qu'il s'agit d'un système fortement couplé, cette variation de la tension piézoélectrique se répercute sur le déplacement qui varie aussi. Dans le cas présent, on diminue le rapport cyclique donc on augmente la résistance équivalente, donc on augmente Vrect ce qui a pour effet de raccourcir la durée des périodes où le courant passe dans le pont redresseur. Pour un déplacement donné, on a alors moins d'amortissement électrique ; ce qui augmente le déplacement.

Cette répercussion importante du circuit électrique sur le déplacement mécanique témoigne aussi du fait que la configuration testée est celle d'un système à fort couplage. L'importance de cette variation du déplacement est typique d'un fort couplage, et rend d'autant plus utile la présente méthode d'estimation, qui est plus simple et peut donc être effectuée plus rapidement et plus souvent avec une moindre consommation.

L'écart entre $x_m$ estimé et $x_m$ réel augmente à partir de t1 puisqu'on arrête d'estimer les paramètres.

Cette variation de $x_m$ n'est pas gênante si les paramètres (les autres paramètres de fonctionnement/rendement du transducteur ?) dépendent peu de $x_m$.

Au delà d'une certaine durée, ou sur détection d'un paramètre indiquant que $x_m$ a varié de plus d'un seuil déterminé par rapport à la valeur estimé et mémorisée en t1, le contrôleur relance 59 une nouvelle itération de la procédure d'estimation et d'ajustement.

Une fois l'ajustement 53 réalisé, à partir de l'instant $t_2$, on constate sur la FIGURE 4a que la puissance récupérée est bien maximisée. Sur cette simulation, l'accéléromètre 15 n'est allumé qu'entre $t_0$ (t=2.5s) et $t_1$ (t=3s), et le microcontrôleur 140 n'est allumé qu'entre $t_0$ (t=2.5s) et $t_1$ (t=4s). Le reste du temps les deux sont éteints, hormis le générateur PWM 148 qui est gardé allumé à rapport cyclique constant et qui contrôle le convertisseur 123. Ces deux dispositifs 140, 15 peuvent être rallumés périodiquement. Une période d2 courte entre deux ajustements 51, 52, 53 utilise davantage de puissance mais s'adapte mieux aux variations de l'accélération, de $C_p$ et de Q, qu'une période longue.

En FIGURE 4a, on observe alors que la puissance diminue temporairement pendant le processus d'ajustement 53 entre $t_1$ et $t_2$, ce qui car il s'agit d'un système à phase non minimale. Elle se met ensuite à augmenter jusqu'à atteindre un niveau de puissance $P_{n+1}$ qui est supérieur au niveau initial $P_n$.

Cette augmentation de la puissance récupérée démontre ainsi que le procédé a amélioré la récolte d'énergie.

Pendant tout le procédé d'optimisation, on notera que le circuit n'est jamais interrompu et la puissance produite n'est jamais totalement interrompue, ce qui permet à l'estimation de porter sur le système sous charge et donc en conditions réelles.

Bien sûr, l'invention n'est pas limitée aux exemples qui viennent d'être décrits et de nombreux aménagements peuvent être apportés à ces exemples sans sortir du cadre de l'invention telle que définie par les revendications.

## Revendications

**1.** Procédé (5) de pilotage d'un circuit de récolte (12) d'énergie électrique produite par un transducteur piézoélectrique (11), lequel réalise un résonateur piézoélectrique (101) sous l'effet de vibrations mécaniques (10) issues d'une source d'excitation mécanique,

dans lequel ledit circuit de récolte reçoit une tension dite piézo (Vp) alternative issue dudit transducteur piézoélectrique, pour produire une tension de sortie (Vout) continue par l'intermédiaire d'un convertisseur (123), lequel est piloté au moyen d'au moins un signal de pilotage (S148) pour présenter au sein dudit circuit de récolte (12) une impédance dite résistance équivalente (R) dont la valeur détermine une tension d'une valeur déterminée qui dépend dudit signal de pilotage,

ledit procédé étant **caractérisé en ce qu'**il comprend au moins une réalisation d'un processus dit d'estimation (51, 52), par un contrôleur électronique dit de pilotage (140) qui est connecté électriquement et opérationnellement au transducteur piézoélectrique (11) et au convertisseur (13), ledit processus d'estimation comprenant les opérations suivantes :

- détection (51), par mesure de tension (M11) dans une partie du circuit de récolte (12) située entre le transducteur piézoélectrique et le convertisseur, de caractéristiques d'un signal dit piézo produit par la tension piézo (Vp), pendant une durée de détection (d0) antérieure à un premier instant (t1) ;

- évaluation (523) de l'amplitude ($a_h$, a1, a3) d'au moins une harmonique dudit signal piézo, comprenant un calcul (523) de l'amplitude ($a_h$) de l'harmonique concernée, desdites caractéristiques détectées, ladite harmonique étant d'un rang supérieur à un ;
- calcul (52) d'un ajustement à appliquer au convertisseur, à partir de ladite amplitude ($a_h$) et d'une valeur dite de résistance actuelle équivalente (Rn) produite pendant ladite durée de détection (d0) sous l'effet d'une valeur dite actuelle ($\delta$n) dudit signal de pilotage (S148), ledit calcul d'ajustement (52) comprenant au moins :

  ◦ un calcul (526) d'une valeur dite de nouvelle résistance équivalente (Rn+1) à produire à partir d'un deuxième instant (t2) postérieur au premier instant (t1), et/ou
  ◦ un calcul (527) d'une nouvelle valeur de signal de commande ($\delta$n+1) à appliquer au convertisseur (13) pour lui faire produire ladite nouvelle résistance équivalente (Rn+1) ;

  ledit procédé comprenant une étape de :

  - application (53, d1, d2) d'un signal de commande (S148) avec ladite nouvelle valeur ($\delta$n+1) au convertisseur.

2. Procédé selon la revendication précédente, **caractérisé en ce que** l'étape de détection (51) s'effectue par mesure directe (M11) du signal de tension sous la forme qu'il présente à la sortie du transducteur.

3. Procédé selon la revendication précédente, **caractérisé en ce qu'**il est mis en oeuvre dans un circuit de récolte où le convertisseur (123) reçoit la tension piézo (Vp) de façon asynchrone sans commande, directement ou par l'intermédiaire d'un circuit de redressement passif sans commande, notamment par composants directionnels bipolaires tels que des diodes.

4. Procédé selon l'une quelconque des revendications précédentes, **caractérisé en ce que** l'étape de calcul d'ajustement (52) comprend au moins :

  - un calcul (524) d'une valeur de capacité maximale (Cp) représentant le fonctionnement du transducteur piézoélectrique au premier instant (n), réalisé à partir de l'amplitude d'harmonique (a3) calculée et de la valeur de résistance actuelle (Rn), ;
  - un calcul (526) de la nouvelle résistance équivalente (Rn+1), réalisé à partir de ladite capacité maximale (Cp) et d'une valeur d'un facteur de qualité (Q), calculée (525) ou mémorisée pour ledit transducteur piézoélectrique,.

5. Procédé selon l'une quelconque des revendications précédentes,

  **caractérisé en ce que** l'étape (524) de calcul de la valeur de capacité maximale (Cp) comprend en outre un calcul d'une valeur de l'amplitude maximale de déplacement ($x_m$), laquelle représente le fonctionnement du transducteur piézoélectrique (11) durant la durée de détection (d0) ;
  et **en ce que** ledit procédé comprend en outre un calcul (525) de la valeur dudit facteur de qualité (Q) à partir de l'amplitude maximale de déplacement ($x_m$) et d'une valeur d'accélération ($\gamma$, gamma) reçue (15) ou lue dans une mémoire électronique.

6. Procédé selon l'une quelconque des revendications précédentes, **caractérisé en ce qu'**il comprend en outre une mesure (15) ou une lecture, pendant la durée de détection (d0), d'une valeur d'accélération ($\gamma$) subie par le transducteur piézoélectrique ;
  et **en ce que** l'étape de calcul d'ajustement (52) comprend au moins :

  - à partir de l'amplitude d'harmonique (a3h) calculée et de la valeur de résistance actuelle (Rn), un calcul (524) d'une valeur de capacité maximale (Cp) et d'une valeur maximale de déplacement ($x_m$), lesquelles représentent le fonctionnement du transducteur piézoélectrique (11) durant la durée de détection (d0) ;
  - à partir de ladite amplitude maximale de déplacement ($x_m$) et de ladite valeur d'accélération ($\gamma$), un calcul (525) d'une valeur d'un facteur de qualité (Q) représentant le fonctionnement du transducteur piézoélectrique (11), et
  - à partir de ladite capacité maximale (Cp) et dudit facteur de qualité (Q), un calcul (527) de la nouvelle valeur de résistance équivalente (Rn+1).

7. Procédé selon l'une quelconque des revendications précédentes, **caractérisé en ce que** l'étape d'évaluation (523) d'au moins une harmonique est réalisée au moins par une méthode récursive par les moindres carrés.

8. Procédé selon l'une quelconque des revendications précédentes, **caractérisé en ce que** l'étape (523) d'évaluation de l'amplitude porte sur l'amplitude (a3) de la troisième harmonique du signal piézo, et notamment uniquement d'un rang égal à trois.

9. Procédé selon la revendication précédente et l'une des revendications 5 ou 6, **caractérisé en ce que** les étapes de calcul (524) de la capacité du transducteur piézoélectrique et (525) du facteur de qualité sont réalisées par résolution du système suivant d'équations :

$$\begin{cases} C_p = \dfrac{\pi(\,4V_{sat} - 3a_3\pi\,)}{6a_3\pi R\omega} \\ x_m = \dfrac{V_{sat}}{\omega R\alpha}\left(\omega R C_p + \dfrac{\pi}{2}\right) \end{cases}$$

où $\alpha_3$ est l'amplitude du 3e harmonique de la tension piézoélectrique.

10. Procédé selon l'une quelconque des revendications précédentes, **caractérisé en ce que** l'étape (523) d'évaluation de l'amplitude porte uniquement sur l'évaluation d'harmoniques de rang supérieur ou égal à trois.

11. Procédé selon l'une quelconque des revendications 1 à 7, **caractérisé en ce que** les étapes de calcul (524) de la capacité du transducteur piézoélectrique et (525) du facteur de qualité sont réalisées par résolution de l'équation suivante :

$$\frac{V_{sat}\sqrt{8C_p\pi R\omega - 4\sqrt{2\pi}\sqrt{\left(C_pR\omega\right)\left(\pi - 2C_pR\omega\right)\text{ArcCos}\left[-1 + \frac{2\pi}{\pi + 2C_pR\omega}\right] + \left(\pi + 2C_pR\omega\right)^2\text{ArcCos}\left[-1 + \frac{2\pi}{\pi + 2C_pR\omega}\right]^2}}}{2C_p\pi R\omega} = a_1$$

où $a_1$ est l'amplitude du premier harmonique du signal de la tension piézoélectrique et où R est la valeur de la résistance au moment de la mesure.

12. Procédé de pilotage selon l'une quelconque des revendications précédentes, **caractérisé en ce qu'**il comprend, pendant une durée de fonctionnement autonome, une pluralité d'itérations comprenant chacune :

   - le processus d'estimation (51, 52, d0) ;
   - un processus d'ajustement (53, d1), dit asservissement, comprenant une application au convertisseur de la nouvelle valeur ($\delta$n+1) de signal de commande (S148) issue dudit processus d'estimation, notamment selon une évolution progressive gérée selon un processus de correction de type proportionnel ou proportionnel-intégral ; et
   - un processus dit de fonctionnement nominal (d2), pendant lequel le contrôleur électronique (140) est maintenu en mode veille tout en continuant à alimenter (S148) le convertisseur (13) avec ladite nouvelle valeur de signal de commande ($\delta$n+1).

13. Dispositif (14) de pilotage d'un circuit (12) de récolte d'énergie électrique produite par un transducteur piézoélectrique (11), lequel réalise un résonateur piézoélectrique (101) sous l'effet de vibrations mécaniques (10) issues d'une source d'excitation mécanique,

   ledit circuit de récolte recevant une tension dite piézo (Vp) alternative issue dudit transducteur piézoélectrique, pour produire une tension de sortie (Vout) continue par l'intermédiaire d'un convertisseur (13), lequel est piloté ($\delta$) au moyen d'au moins un signal de pilotage (S148) pour présenter au sein dudit circuit une impédance dite résistance équivalente (R) dont la valeur détermine une tension d'opération du convertisseur d'une valeur qui dépend dudit signal de pilotage,
   ledit dispositif (14) comprenant un contrôleur électronique de pilotage (140) programmé pour mettre en œuvre toutes les étapes d'un procédé de pilotage (5, 140) selon l'une quelconque des revendications précédentes.

14. Circuit de récolte (12) d'énergie électrique venant d'un résonateur piézoélectrique (101), ou dispositif de génération d'énergie électrique comprenant un tel circuit de récolte d'énergie électrique et un résonateur piézoélectrique alimentant ledit circuit de récolte,

ledit circuit de récolte comprenant au moins :

- un étage redresseur (121) connecté pour recevoir une tension piézo (Vp) alternative, formant un signal piézo, de la part dudit résonateur piézoélectrique et produisant une tension redressée (Vr) ;
- optionnellement, un dispositif de stockage intermédiaire d'énergie électrique (13) recevant la tension redressée ;
- un convertisseur régulé (13) pilotable fournissant une tension de sortie (Vout),

**caractérisé en ce que** ledit circuit de récolte d'énergie électrique comprend un dispositif de pilotage selon la revendication 13 qui est connecté pour mesurer ledit signal piézo et piloter ledit convertisseur.

15. Circuit selon la revendication précédente, **caractérisé en ce que** le convertisseur (123) est réalisé par au moins un convertisseur continu-continu fonctionnant par hachage et qui est piloté (S148) en modulation de largeur d'impulsion ($\delta$).

16. Dispositif de génération d'énergie électrique comprenant un circuit (12) de récolte d'énergie électrique selon la revendication 14 ou 15, et un résonateur piézoélectrique (101) alimentant ledit circuit de récolte, le dispositif étant **caractérisé en ce qu'**il comprend en outre au moins un accéléromètre (15) agencé pour mesurer une accélération ($\gamma$) produite par la source d'excitation (100),

**en ce que** le contrôleur de pilotage (140) dudit circuit de récolte est connecté pour recevoir ladite mesure d'accélération,

et **en ce que** ledit contrôleur est agencé pour mettre en œuvre toutes les étapes d'un procédé de pilotage (5) selon l'une quelconque des revendications 6 à 12.

17. Dispositif (1) électrique ou électronique, comprenant un dispositif de pilotage selon la revendication 13, ou un circuit de récolte selon l'une quelconque des revendications 14 ou 15, ou un dispositif de génération d'énergie électrique selon la revendication 16, agencé pour lui fournir une alimentation électrique autonome ou un complément d'alimentation électrique, sous l'effet d'une excitation mécanique en vibration (10) fournie par l'environnement matériel dudit dispositif électrique ou électronique (1).

**Patentansprüche**

1. Verfahren (5) zur Steuerung einer Schaltung (12) zur Gewinnung elektrischer Energie, die von einem piezoelektrischen Wandler (11) erzeugt wird, der unter der Einwirkung von mechanischen Vibrationen (10), die von einer mechanischen Anregerquelle stammen, einen piezoelektrischen Resonator (101) ausbildet,

wobei die Gewinnungsschaltung eine so genannte Piezo-Wechselspannung (Vp) empfängt, die von dem piezoelektrischen Wandler stammt, um mittels eines Wandlers (123), der mittels wenigstens eines Steuersignals (S148) gesteuert wird, eine Ausgangsgleichspannung (Vout) zu erzeugen, um im Inneren der Gewinnungsschaltung (12) eine Impedanz, so genannter äquivalenter Widerstand (R), aufzuweisen, deren Wert eine Spannung mit einem bestimmten Wert festlegt, der von dem Steuersignal abhängt,
wobei das Verfahren **dadurch gekennzeichnet ist, dass** es wenigstens eine Durchführung eines so genannten Schätzungsprozesses (51, 52) durch eine elektronische Steuervorrichtung, so genannte Steuerung (140), umfasst, die mit dem piezoelektrischen Wandler (11) und mit dem Wandler (13) elektrisch verbunden und wirkverbunden ist, wobei der Schätzungsprozess die folgenden Operationen umfasst:

- Detektion (51), durch Spannungsmessung (M11), in einem Teil der Gewinnungsschaltung (12), der sich zwischen dem piezoelektrischen Wandler und dem Wandler befindet, von Merkmalen eines so genannten Piezo-Signals, das durch die Piezo-Spannung (Vp) erzeugt wird, während einer Detektionsdauer (d0) vor einem ersten Zeitpunkt (t1);
- Auswertung (523) der Amplitude ($a_h$, a1, a3) wenigstens einer Oberschwingung des Piezo-Signals, die eine Berechnung (523) der Amplitude ($a_h$) der betroffenen Oberschwingung mit den detektierten Merkmalen umfasst; wobei die Oberschwingung einer Ordnungszahl größer eins ist;
- Berechnung (52) einer Anpassung, die an dem Wandler vorzunehmen ist, ausgehend von der Amplitude

($a_h$) und von einem so genannten aktuellen äquivalenten Widerstandswert (Rn), der während der Detektionsdauer (d0) unter der Einwirkung eines so genannten aktuellen Werts ($\delta$n) des Steuersignals (S148) erzeugt wird, wobei die Berechnung (52) der Anpassung wenigstens Folgendes umfasst:

- ○ eine Berechnung (526) eines so genannten neuen äquivalenten Widerstandswerts (Rn+1), der ausgehend von einem zweiten Zeitpunkt (t2) nach dem ersten Zeitpunkt (t1) zu erzeugen ist, und/oder
- ○ eine Berechnung (527) eines neuen Steuersignalwerts ($\delta$n+1), der auf den Wandler (13) anzuwenden ist, um ihn zu veranlassen, den neuen äquivalenten Widerstand (Rn+1) zu erzeugen;

wobei das Verfahren einen Schritt umfasst zum:

- Anwenden (53, d1, d2) eines Steuersignals (S148) mit dem neuen Wert ($\delta$n+1) auf den Wandler.

2. Verfahren nach dem vorhergehenden Anspruch, **dadurch gekennzeichnet, dass** der Detektionsschritt (51) durch direkte Messung (M11) des Spannungssignals in der Form, die es am Ausgang des Wandlers aufweist, erfolgt.

3. Verfahren nach dem vorhergehenden Anspruch, **dadurch gekennzeichnet, dass** es in einer Gewinnungsschaltung durchgeführt wird, wo der Wandler (123) die Piezo-Spannung (Vp) asynchron ohne Steuerung, unmittelbar oder mittels einer passiven Gleichrichterschaltung ohne Steuerung, insbesondere über bipolare direktionale Komponenten wie Dioden, empfängt.

4. Verfahren nach einem der vorhergehenden Ansprüche, **dadurch gekennzeichnet, dass** der Schritt der Berechnung (52) der Anpassung wenigstens Folgendes umfasst:

- eine Berechnung (524) eines maximalen Kapazitätswerts (Cp), der den Betrieb des piezoelektrischen Wandlers zum ersten Zeitpunkt (n) repräsentiert, die ausgehend von der berechneten Oberschwingungsamplitude (a3) und dem aktuellen Widerstandswert (Rn) durchgeführt wird;
- eine Berechnung (526) des neuen äquivalenten Widerstands (Rn+1), die ausgehend von der maximalen Kapazität (Cp) und von einem Wert eines für den piezoelektrischen Wandler berechneten (525) oder gespeicherten Qualitätsfaktors (Q) durchgeführt wird.

5. Verfahren nach einem der vorhergehenden Ansprüche, **dadurch gekennzeichnet, dass** der Schritt der Berechnung (524) des maximalen Kapazitätswerts (Cp) ferner eine Berechnung eines maximalen Bewegungsamplitudenwerts ($x_m$) umfasst, der den Betrieb des piezoelektrischen Wandlers (11) während der Detektionsdauer (d0) repräsentiert; und dadurch, dass das Verfahren ferner eine Berechnung (525) des Wertes des Qualitätsfaktors (Q) ausgehend von der maximalen Bewegungsamplitude ($x_m$) und von einem empfangenen (15) oder aus einem elektronischen Speicher gelesenen Beschleunigungswert ($\gamma$, gamma) umfasst.

6. Verfahren nach einem der vorhergehenden Ansprüche, **dadurch gekennzeichnet, dass** es ferner eine Messung (15) oder ein Lesen, während der Detektionsdauer (d0), eines Wertes der Beschleunigung ($\gamma$), die der piezoelektrische Wandler erfährt, umfasst; und dadurch, dass der Schritt der Berechnung (52) der Anpassung wenigstens Folgendes umfasst:

- ausgehend von der berechneten Oberschwingungsamplitude (a3h) und von dem aktuellen Widerstandswert (Rn), eine Berechnung (524) eines maximalen Kapazitätwertes (Cp) und eines maximalen Bewegungswertes ($x_m$), die den Betrieb des piezoelektrischen Wandlers (11) während der Detektionsdauer (d0) repräsentieren;
- ausgehend von der maximalen Bewegungsamplitude ($x_m$) und von dem Beschleunigungswert ($\gamma$), eine Berechnung (525) eines Wertes eines Qualitätsfaktors (Q), der den Betrieb des piezoelektrischen Wandlers (11) repräsentiert, und
- ausgehend von der maximalen Kapazität (Cp) und von dem Qualitätsfaktor (Q), eine Berechnung (527) des neuen äquivalenten Widerstandswerts (Rn+1).

7. Verfahren nach einem der vorhergehenden Ansprüche, **dadurch gekennzeichnet, dass** der Schritt der Auswertung (523) wenigstens einer Oberschwingung durch wenigstens eine rekursive Methode der kleinsten Quadrate durchgeführt wird.

8. Verfahren nach einem der vorhergehenden Ansprüche, **dadurch gekennzeichnet, dass** der Schritt der Auswertung (523) der Amplitude sich auf die Amplitude (a3) der dritten Oberschwingung des Piezo-Signals, und insbesondere nur einer Ordnungszahl gleich drei, bezieht.

9.  Verfahren nach dem vorhergehenden Anspruch und einem der Ansprüche 5 oder 6, **dadurch gekennzeichnet, dass** die Schritte der Berechnung (524) der Kapazität des piezoelektrischen Wandlers und der Berechnung (525) des Qualitätsfaktors durch Auflösung des folgenden Gleichungssystems durchgeführt werden:

$$\begin{cases} C_p = \dfrac{\pi(\,4V_{sat} - 3a_3\pi\,)}{6a_3\pi R\omega} \\ x_m = \dfrac{V_{sat}}{\omega R\alpha}\left(\omega R C_p + \dfrac{\pi}{2}\right) \end{cases}$$

wo $\alpha_3$ die Amplitude der 3. Oberschwingung der piezoelektrischen Spannung ist.

10.  Verfahren nach einem der vorhergehenden Ansprüche, **dadurch gekennzeichnet, dass** der Schritt der Auswertung (523) der Amplitude sich nur auf die Auswertung von Oberschwingungen einer Ordnungszahl größer oder gleich drei bezieht.

11.  Verfahren nach einem der Ansprüche 1 bis 7, **dadurch gekennzeichnet, dass** die Schritt der Berechnung (524) der Kapazität des piezoelektrischen Wandlers und der Berechnung (525) des Qualitätsfaktors durch Auflösung der folgenden Gleichung durchgeführt werden:

$$\frac{V_{sat}\sqrt{8C_p\pi R\omega - 4\sqrt{2\pi}\sqrt{(C_p R\omega)(\pi - 2C_p R\omega)\mathrm{ArcCos}\left[-1 + \frac{2\pi}{\pi + 2C_p R\omega}\right] + (\pi + 2C_p R\omega)^2\mathrm{ArcCos}\left[-1 + \frac{2\pi}{\pi + 2C_p R\omega}\right]^2}}}{2C_p\pi R\omega} = a_1$$

wo $\alpha_1$ die Amplitude der ersten Oberschwingung des Signals der piezoelektrischen Spannung ist und wo R der Wert des Widerstands zum Zeitpunkt der Messung ist.

12.  Steuerungsverfahren nach einem der vorhergehenden Ansprüche, **dadurch gekennzeichnet, dass** es, während der Dauer eines autonomen Betriebs, eine Mehrzahl von Iterationen umfasst, die jede Folgendes umfassen:

- den Schätzungsprozess (51, 52, d0);
- einen Anpassungsprozess (53, d1), so genannte Regelung, der eine Anwendung auf den Wandler des neues Werts (δn+1) des Steuersignals (S148), der aus dem Schätzungsprozess stammt, umfasst, insbesondere gemäß einer progressiven Entwicklung, die gemäß einem Korrekturprozess des proportionalen oder proportional-integralen Typs gemanagt wird; und
- einen so genannten nominalen Betriebsprozess (d2), während dessen die elektronische Steuerung (140) im Standby-Betrieb gehalten wird, während gleichzeitig der Wandler (13) weiterhin mit dem neuen Steuersignalwert (δn+1) versorgt (S148) wird.

13.  Vorrichtung (14) zur Steuerung einer Schaltung (12) zur Gewinnung elektrischer Energie, die von einem piezoelektrischen Wandler (11) erzeugt wird, der unter der Einwirkung von mechanischen Vibrationen (10), die von einer mechanischen Anregerquelle stammen, einen piezoelektrischen Resonator (101) ausbildet,

wobei die Gewinnungsschaltung eine so genannte Piezo-Wechselspannung (Vp) empfängt, die von dem piezoelektrischen Wandler stammt, um mittels eines Wandlers (13), der mittels wenigstens eines Steuersignals (S148) gesteuert (δ) wird, eine Ausgangsgleichspannung (Vout) zu erzeugen, um im Inneren der Gewinnungsschaltung (12) eine Impedanz, so genannter äquivalenter Widerstand (R), aufzuweisen, deren Wert eine Betriebsspannung mit einem bestimmten Wert festlegt, der von dem Steuersignal abhängt, wobei die Vorrichtung (14) eine elektronische Steuervorrichtung (140) umfasst, die programmiert ist, um sämtliche Schritte eines Steuerverfahrens (5, 140) nach einem der vorstehenden Ansprüche durchzuführen.

14.  Schaltung (12) zur Gewinnung elektrischer Energie, die von einem piezoelektrischen Resonator (101) kommt, oder Vorrichtung zur Erzeugung elektrischer Energie, die eine derartige Schaltung zur Gewinnung elektrischer Energie und einen piezoelektrischen Resonator zur Versorgung der Gewinnungsschaltung umfasst,

wobei die Gewinnungsschaltung wenigstens Folgendes umfasst:

- eine Gleichrichterstufe (121), die angeschlossen ist, um eine Piezo-Wechselspannung (Vp), die ein Piezo-Signal bildet, von dem piezoelektrischen Resonator zu empfangen, und eine gleichgerichtete Spannung (Vr) erzeugt;
- optional eine Vorrichtung zur Zwischenspeicherung elektrischer Energie (13), die die gleichgerichtete Spannung empfängt;
- einen steuerbaren geregelten Wandler (13), der eine Ausgangsspannung (Vout) bereitstellt,

**dadurch gekennzeichnet, dass** die Schaltung zur Gewinnung elektrischer Energie eine Steuervorrichtung nach Anspruch 13 umfasst, die angeschlossen ist, um das Piezo-Signal zu messen und den Wandler zu steuern.

15. Schaltung nach dem vorhergehenden Anspruch, **dadurch gekennzeichnet, dass** der Wandler (13) von wenigstens einem DC-DC-Wandler ausgebildet ist, der durch Hashing funktioniert und der in Pulsweitenmodulation ($\delta$) gesteuert (S148) wird.

16. Vorrichtung zur Erzeugung elektrischer Energie umfassend eine Schaltung (12) zur Gewinnung elektrischer Energie nach Anspruch 14 oder 15 und einen piezoelektrischen Resonator (101) zur Versorgung der Gewinnungsschaltung, wobei die Vorrichtung **dadurch gekennzeichnet ist, dass** sie ferner wenigstens einen Beschleunigungsmesser (15) umfasst, der eingerichtet ist, um eine Beschleunigung ($\gamma$), die von der Anregerquelle (100) erzeugt wird, zu messen,

dass die Vorrichtung zur Steuerung (14) der Gewinnungsschaltung angeschlossen ist, um die Beschleunigungsmessung zu empfangen, und dadurch, dass die Vorrichtung eingerichtet ist, um sämtliche Schritte eines Steuerverfahrens (5) nach einem der Ansprüche 6 bis 12 durchzuführen.

17. Elektrische oder elektronische Vorrichtung (1), umfassend eine Steuervorrichtung nach Anspruch 13 oder eine Gewinnungsschaltung nach einem der Ansprüche 14 oder 15 oder eine Vorrichtung zur Erzeugung elektrischer Energie nach Anspruch 16, die eingerichtet ist, um ihr eine autonome elektrische Versorgung oder eine ergänzende elektrische Versorgung unter der Einwirkung einer mechanischen Anregung zur Schwingung (10), die von der Hardware-Umgebung der elektrischen oder elektronischen Vorrichtung (1) bereitgestellt ist, bereitzustellen.

**Claims**

1. Method (5) for controlling a harvesting circuit (12) for electrical energy produced by a piezoelectric transducer (11) in the form of a piezoelectric resonator (101) under the effect of mechanical vibrations (10) originating from a mechanical excitation source,

in which said harvesting circuit receives an alternating "piezo" voltage (Vp) originating from said piezoelectric transducer to produce a direct output voltage (Vout) by way of a converter (123) that is controlled by means of at least one control signal (S148) in order to have within said harvesting circuit (12) an impedance (R), or "equivalent resistance", the value of which establishes a voltage of a certain value that depends on said control signal, said method being **characterised in that** it comprises at least one performance of an "estimation" process (51, 52) by an electronic "control" driver (140) which is electrically and operationally connected to the piezoelectric transducer (11) and to the converter (13), said estimation process comprising the following operations:

- detection (51), by voltage measurement (M11) in a part of the harvesting circuit (12) located between the piezoelectric transducer and the converter, of characteristics of a "piezo" signal produced by the piezo voltage (Vp), during a detection period (d0) prior to a first instant (t1);
- evaluation (523) of the amplitude ($a_h$, a1, a3) of at least one harmonic of said piezo signal, comprising a calculation (523) of the amplitude ($a_h$) of the harmonic in question, of said detected characteristics, said harmonic being of a rank greater than one; and
- calculation (52) of an adjustment to be applied to the converter, on the basis of said amplitude ($a_h$) and a "current equivalent resistance" value (Rn) produced during said detection period (d0) under the effect of a "current" value ($\delta$n) of said control signal (S148), said adjustment calculation (52) comprising at least:

○ a calculation (526) of a "new equivalent resistance" value (Rn + 1) to be produced on the basis of a second instant (t2) subsequent to the first instant (t1), and/or
○ a calculation (527) of a new control signal value ($\delta$n + 1) to be applied to the converter (13) to cause it to produce said new equivalent resistance (Rn + 1);

said method comprising a step of:

- applying (53, d1, d2) a control signal (S148) with said new value ($\delta$n + 1) to the converter.

2. Method according to the preceding claim, **characterised in that** the detection step (51) is carried out by direct measurement (M11) of the voltage signal in the form it has at the transducer outlet.

3. Method according to the preceding claim, **characterised in that** it is implemented in a harvesting circuit where the converter (123) receives the piezo voltage (Vp) asynchronously without control, directly or by way of a passive rectifier circuit without control, in particular by bipolar directional components such as diodes.

4. Method according to any one of the preceding claims, **characterised in that** the adjustment calculation step (52) comprises at least:

- a calculation (524) of a maximum capacitance value (Cp) representing operation of the piezoelectric transducer at the first instant (n), performed on the basis of the calculated harmonic amplitude (a3) and the current resistance value (Rn); and
- a calculation (526) of the new equivalent resistance (Rn + 1), performed on the basis of said maximum capacitance (Cp) and a value of a quality factor (Q) calculated (525) or saved for said piezoelectric transducer.

5. Method according to any one of the preceding claims, **characterised in that** the step (524) of calculating the maximum capacitance value (Cp) further comprises calculation of a value of the maximum displacement amplitude ($x_m$) which represents operation of the piezoelectric transducer (11) during the detection period (d0);
and **in that** said method further comprises calculation (525) of the value of said quality factor (Q) on the basis of the maximum displacement amplitude ($x_m$) and an acceleration value ($\gamma$, gamma) received (15) or read from an electronic memory.

6. Method according to any one of the preceding claims, **characterised in that** it further comprises measurement (15) or reading, during the detection period (d0), of an acceleration value ($\gamma$) undergone by the piezoelectric transducer; and **in that** the adjustment calculation step (52) comprises at least:

- on the basis of the calculated harmonic amplitude (a3h) and the current resistance value (Rn), calculation (524) of a maximum capacitance value (Cp) and a maximum displacement value ($x_m$) which represent operation of the piezoelectric transducer (11) during the detection period (d0);
- on the basis of said maximum displacement amplitude ($x_m$) and said acceleration value ($\gamma$), calculation (525) of a value of a quality factor (Q) representing operation of the piezoelectric transducer (11), and
- on the basis of said maximum capacitance (Cp) and said quality factor (Q), calculation (527) of the new equivalent resistance value (Rn + 1).

7. Method according to any one of the preceding claims, **characterised in that** the step of evaluating (523) at least one harmonic is performed at least by a recursive least squares method.

8. Method according to any one of the preceding claims, **characterised in that** the step of evaluating (523) the amplitude relates to the amplitude (a3) of the third harmonic of the piezo signal, and in particular solely of a rank equal to three.

9. Method according to the preceding claim and one of claims 5 or 6, **characterised in that** the steps of calculating (524) the capacitance of the piezoelectric transducer and of calculating (525) the quality factor are performed by solving the following system of equations:

$$
\begin{cases}
C_p = \dfrac{\pi(\,4V_{sat} - 3a_3\pi\,)}{6a_3\pi R\omega} \\[2mm]
x_m = \dfrac{V_{sat}}{\omega R\alpha}\left(\omega R C_p + \dfrac{\pi}{2}\right)
\end{cases}
$$

where $\alpha_3$ is the amplitude of the third harmonic of the piezoelectric voltage.

10. Method according to any one of the preceding claims, **characterised in that** the step of evaluating (523) the amplitude relates solely to the evaluation of harmonics of a rank greater than or equal to three.

11. Method according to any one of claims 1 to 7, **characterised in that** the steps of calculating (524) the capacitance of the piezoelectric transducer and of calculating (525) the quality factor are performed by solving the following equation:

$$
\frac{V_{sat}\sqrt{8C_p\pi R\omega - 4\sqrt{2\pi}\sqrt{(C_pR\omega)(\pi - 2C_pR\omega)\mathrm{ArcCos}\left[-1 + \frac{2\pi}{\pi + 2C_pR\omega}\right] + (\pi + 2C_pR\omega)^2\mathrm{ArcCos}\left[-1 + \frac{2\pi}{\pi + 2C_pR\omega}\right]^2}}}{2C_p\pi R\omega} = a_1
$$

where $a_1$ is the amplitude of the first harmonic of the piezoelectric voltage signal and where R is the resistance value at the time of measurement.

12. Control method according to any one of the preceding claims, **characterised in that** it comprises, during a period of autonomous operation, a plurality of iterations each comprising:

- the estimation process (51, 52, d0);
- an adjustment, "regulation" process (53, d1), comprising application to the converter of the new value ($\delta n + 1$) of the control signal (S148) originating from said estimation process, in particular according to a progressive development managed according to a proportional or proportional-integral type correction process; and
- a "nominal operation" process (d2), during which the electronic driver (140) is kept in standby mode while continuing to supply (S148) the converter (13) with said new control signal value ($\delta n + 1$).

13. Device (14) for controlling a harvesting circuit (12) for electrical energy produced by a piezoelectric transducer (11) in the form of a piezoelectric resonator (101) under the effect of mechanical vibrations (10) originating from a mechanical excitation source,

said harvesting circuit receiving an alternating "piezo" voltage (Vp) originating from said piezoelectric transducer to produce a direct output voltage (Vout) by way of a converter (13) that is controlled ($\delta$) by means of at least one control signal (S148) in order to have within said circuit an "equivalent resistance" impedance (R) the value of which establishes an operating voltage for the converter of a value that depends on said control signal, said device (14) comprising an electronic control driver (140) programmed to implement all the steps of a control method (5, 140) according to any one of the preceding claims.

14. Harvesting circuit (12) for electrical energy coming from a piezoelectric resonator (101), or device for generating electrical energy comprising such an electrical energy harvesting circuit and a piezoelectric resonator supplying said harvesting circuit,

said harvesting circuit comprising at least:

- a rectifier stage (121) connected to receive an alternating piezo voltage (Vp) forming a piezo signal from said piezoelectric resonator and producing a rectified voltage (Vr);
- optionally a device for intermediate storage of electrical energy (13) receiving the rectified voltage; and
- a controllable regulated converter (13) supplying an output voltage (Vout),

**characterised in that** said electrical energy harvesting circuit comprises a control device according to claim 13 which is connected to measure said piezo signal and control said converter.

**15.** Circuit according to the preceding claim, **characterised in that** the converter (123) is embodied by at least one DC-DC converter operating by chopping and which is controlled (S148) in pulse-width modulation ($\delta$).

**16.** Device for generating electrical energy, comprising a harvesting circuit (12) for electrical energy according to claim 14 or 15, and a piezoelectric resonator (101) supplying said harvesting circuit, the device being **characterised in that** it further comprises at least one accelerometer (15) arranged to measure an acceleration ($\gamma$) produced by the excitation source (100),

in that the control driver (140) of said harvesting circuit is connected to receive said acceleration measurement, and **in that** said driver is arranged to implement all the steps of a control method (5) according to any one of claims 6 to 12.

**17.** Electrical or electronic device (1) comprising a control device according to claim 13, or a harvesting circuit according to either one of claims 14 or 15, or a device for generating electrical energy according to claim 16, arranged to provide it with an autonomous electrical power supply or a supplemental electrical supply under the effect of vibrational mechanical excitation (10) supplied by the hardware environment of said electrical or electronic device (1).

**Fig. 1**

**Fig. 2**

**Fig. 3**

| | |
|---|---|
| **50** | mesure, calcul et/ou estimation<br>des paramètres constants :<br>- M (masse)<br>- k (raideur)<br>- $\omega_0$ (fréquence propre)<br>- α (coefficient de couplage) |
| **pré-caractérisation** | |

**59**

**55**

charge de la batterie

**51, 52**

**processus d'estimation**
(recalcul des paramètres de pilotage)

51
- (511) réveil de MC et Accéléromètre
  & lecture des paramètres constants
- (512) détection & enregistrement V(t)
52
- (523) calcul de l'amplitude $a_h$ (e.g. a1 ou a3)
- (524) calcul de Cp et $x_m$
- (525) calcul de Q
- (526) calcul de R (polynôme °5)
- (527) calcul de δ
- (extinction de Acc)

**5**

**53**

**processus d'ajustement**
application des nouveaux
paramètres de pilotage

- lecture de δ
- application progressive de δ par correcteur P
  ou P/I
- extinction de MC et Accéléromètre

**54**

**processus de
fonctionnement nominal**

**Fig. 4**

Fig. 4a

Fig. 4b

Fig. 4c

Fig. 4d

Fig. 4e

**Fig. 5**

**Adaptation d'impédance**

**Fig. 6**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 1612059 A
- US 2015263643 A
- KR 1020040131005 A
- US 20030034715 A1
- WO 2017191436 A1

**Littérature non-brevet citée dans la description**

- **OTTMAN et al.** Adaptive piezoelectric energy harvesting circuit for wireless remote power supply. *IEEE Transactions on Power Electronics*, September 2002, vol. 17 (5), 669-676
- **XIA et al.** Direct calculation of source impedance to adaptive maximum power point tracking for broadband vibration. *Journal of Intelligent Material Systems and Structures*, September 2016
- **SHU ; LIEN**. Analysis of power output for piezoelectric energy harvesting systems. *Smart Materials and Structures*, 2006, vol. 15, 1499-1512
- **K. H. YOUSSEF ; A. EL ZAWAWI ; O. A. SEBAKHY**. Recursive Least Squares Harmonic Identification in Active Power Filters. *Proceedings of the European Control Conference*, 2007